(19) Europäisches Patentamt / European Patent Office / Office européen des brevets

(11) **EP 3 857 639 B1**

(12) **FASCICULE DE BREVET EUROPEEN**

(45) Date de publication et mention de la délivrance du brevet:
**21.02.2024 Bulletin 2024/08**

(21) Numéro de dépôt: **19782947.6**

(22) Date de dépôt: **26.09.2019**

(51) Classification Internationale des Brevets (IPC):
**H01M 10/48** (2006.01)   **H01M 10/633** (2014.01)
**G01R 31/382** (2019.01)

(52) Classification Coopérative des Brevets (CPC):
**H01M 10/633; H01M 10/482;** Y02E 60/10

(86) Numéro de dépôt international:
**PCT/EP2019/076102**

(87) Numéro de publication internationale:
**WO 2020/064959 (02.04.2020 Gazette 2020/14)**

(54) **PROCEDE ET DISPOSITIF DE MESURE EN TEMPS REEL ET IN SITU DES DONNEES THERMODYNAMIQUES D'UNE BATTERIE (ENTHALPIE ET ENTROPIE)**

VERFAHREN UND VORRICHTUNG ZUR MESSUNG VON THERMODYNAMISCHEN BATTERIEDATEN (ENTHALPIE UND ENTROPIE) IN SITU UND IN ECHTZEIT

PROCESS AND DEVICE FOR MEASURING THERMODYNAMIC DATA OF A BATTERY (ENTHALPY AND ENTROPY) IN SITU AND IN REAL TIME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2018 FR 1858919**

(43) Date de publication de la demande:
**04.08.2021 Bulletin 2021/31**

(73) Titulaire: **Institut Polytechnique de Grenoble 38000 Grenoble (FR)**

(72) Inventeurs:
• **EL OUTMANI, Sohaib**
  **95140 Garges lès Gonesse (FR)**
• **SENAME, Olivier**
  **38100 Grenoble (FR)**
• **GRANJON, Pierre**
  **38470 Vinay (FR)**
• **YAZAMI, Rachid**
  **Singapour 557325 (SG)**

(74) Mandataire: **Hautier IP 20, rue de la Liberté 06000 Nice (FR)**

(56) Documents cités:
**US-A1- 2016 146 895     US-A1- 2017 146 608**

• **DUONG VAN-HUAN ET AL: "Online state of charge and model parameters estimation of the LiFePO4battery in electric vehicles using multiple adaptive forgetting factors recursive least-squares", JOURNAL OF POWER SOURCES, ELSEVIER SA, CH, vol. 296, 24 juillet 2015 (2015-07-24), pages 215-224, XP029259464, ISSN: 0378-7753, DOI: 10.1016/J.JPOWSOUR.2015.07.041**

**Description**

*Domaine technique*

Le domaine de l'invention est celui des batteries électriques.
Plus précisément, l'invention concerne un procédé de mesure en temps réel et in situ des données thermodynamiques d'une batterie (enthalpie et entropie).
L'invention vise également un dispositif pour la mise en oeuvre de ce procédé.

*Etat de l'art*

Le terme batterie désigne un assemblage d'accumulateurs rechargeables connectés ensemble pour obtenir la capacité et la tension désirées. Un accumulateur désigne un dispositif électrochimique unitaire (cellule) comprenant deux électrodes séparées par un électrolyte. Dans le présent exposé, le terme "batterie" désignera à la fois un assemblage de cellules électrochimiques et une cellule unitaire.
Les batteries rechargeables et notamment les batteries Li-Ion sont déjà présentes dans une multitude d'applications parmi lesquels on peut citer le stockage d'énergie éolienne ou solaire, les téléphones portables, les avions et des automobiles. Dans ce dernier secteur où la part de marché des véhicules hybrides ou électriques devrait bondir de 1% à 30% dans les prochaines années, les batteries vont connaître un essor sans précédent.
Dans toutes ces applications, le diagnostic des batteries représentent un enjeu majeur en termes de performance et de sécurité. L'actualité est riche d'exemples de problèmes de surchauffe, voire d'incendie ou d'explosion de batteries.
Il est donc primordial de développer des outils qui permettent de mieux diagnostiquer l'état des batteries, et notamment l'état de charge et de santé des batteries.
Avec les perspectives de développement évoquées ci-dessus, une optimisation de fonctionnement et de la sécurité des batteries, aussi minime soit-elle, aurait un impact considérable. Cette optimisation passe par l'amélioration des moyens de diagnostic de l'état interne des batteries.
On sait qu'il existe un lien entre l'état interne d'une batterie et les grandeurs thermodynamiques qui lui sont associées, en particulier la variation d'enthalpie et la variation d'entropie. En effet, il a été observé que les profils thermodynamiques présentent une dépendance avec certaines caractéristiques de la batterie. Ces profils dépendent du vieillissement thermique, du vieillissement par charge-décharge, du vieillissement par surcharge mais aussi de l'état de charge de la batterie. Une modification des profils a aussi été observée dans le cas où la batterie a été surchargée. Une connaissance des données thermodynamiques est donc une riche source d'informations sur l'état et le passé d'une batterie.
Par ailleurs, il est essentiel de connaître la thermodynamique des réactions aux électrodes et des transformations physiques dont les batteries sont le siège, pour prédire les performances et la stabilité des batteries.
Ainsi, la densité d'énergie reflète t'elle les quantités totales de charges échangées de manière réversible et le potentiel auquel ces échanges se produisent. En outre, le cycle de vie renvoie à la stabilité des états ou phases qui résultent des transformations aux électrodes dans les processus de charge et de décharge. Ces processus sont contrôlés par la thermodynamique.
Il y a donc un lien entre l'état interne de la batterie et les grandeurs thermodynamiques qui lui sont associées (variation d'enthalpie et variation d'entropie).
L'état interne d'une batterie est donné notamment par les caractéristiques suivantes: vieillissement thermique, vieillissement par charge décharge, vieillissement par surcharge, état de charge de la batterie, surcharge. Une connaissance des données thermodynamiques est donc une riche source d'information sur l'état et le passé d'une batterie.
Nombre de techniques ont été développées et appliquées pour évaluer les cinétiques thermochimiques des réactions aux électrodes, en particulier, des méthodes électroanalytiques (Voltamétrie cyclique, potentiométrie,..), les techniques spectroscopiques (diffraction aux rayons X, RMN, LEED..).
Les documents brevets EP1924849, US8446127, US9599584, US20160146895, WO2017204750, entre autres, décrivent des procédés d'évaluation de l'état de charge et de l'état de santé des batteries, au travers des profils thermodynamiques mesurés.
Dans cet art antérieur, la méthode de mesure des profils thermodynamiques est une méthode standard qui exige des conditions de laboratoire et un temps significatif de l'ordre de plusieurs jours à plusieurs semaines. Cette méthode standard également dénommée méthode ETM "Electro-chemical Thermodynamic Measurement", consiste essentiellement à mettre en oeuvre un dispositif comprenant:

    1 Un dispositif permettant de contrôler la température des batteries
    2 Un potentiomètre-galvanomètre avec une mesure de tension et de courant d'une grande précision

3 Un ordinateur pour contrôler le processus de mesure thermodynamique et collecter les données

Pour mesurer $\Delta S$ (la variation d'entropie) avec ce dispositif, le procédé ETM se base sur la formule suivante :

$$\Delta S = F \left( \frac{\partial OCV}{\partial T_{bat}} \right)_x$$

où

- $\Delta S$ est la variation d'entropie
- $F$ est la constante de Faraday
- $OCV$ est la tension en circuit ouvert
- $T_{bat}$ est la température de la batterie
- $x$ est l'état de charge

En pratique, pour mesurer $\Delta S$ on se met à un état de charge donné, on coupe le courant et on attend plusieurs heures pour que la tension aux bornes de la batterie se relaxe et tende vers OCV. Ensuite, on fait varier la température de la batterie, ce qui a pour effet de varier la tension. Il existe une relation linéaire entre $T_{bat}$ et $OCV$. Il ne reste plus qu'à déterminer le coefficient reliant les deux et à le multiplier par la constante de faraday pour obtenir $\Delta S$. Pour obtenir un profil complet, il faut réitérer la mesure à différents états de charge.

$OCV$ est obtenue directement en mesurant la tension après relaxation et $\Delta H$ (la variation d'enthalpie) est obtenue à l'aide de l'équation (4)

$$\Delta H = -F.OCV - T_{bat}\Delta S \quad (4)$$

Il apparaît donc que cette mesure standard ETM des profils thermodynamiques est une technique de laboratoire fastidieuse, longue, exigeant une certaine maîtrise des conditions d'opération de la batterie. Cette méthode standard ETM n'est pas utilisable in situ, en ligne et en temps réel.

Dans ces circonstances, la présente invention vise à satisfaire à au moins l'un des objectifs énoncés ci-après.

☞L'un des objectifs essentiels de la présente invention est de fournir un procédé de mesure, in situ, en ligne et en temps réel, de la variation d'entropie d'une batterie.

☞L'un des objectifs essentiels de la présente invention est de fournir un procédé simple et fiable de mesure, in situ, en ligne et en temps réel, de la variation d'entropie d'une batterie.

☞L'un des objectifs essentiels de la présente invention est de fournir un procédé performant de mesure, in situ, en ligne et en temps réel, de la variation d'entropie d'une batterie.

☞L'un des objectifs essentiels de la présente invention est de fournir un procédé rapide de mesure, in situ, en ligne et en temps réel, de la variation d'entropie d'une batterie.

☞L'un des objectifs essentiels de la présente invention est de fournir un procédé économique de mesure, in situ, en ligne et en temps réel, de la variation d'entropie d'une batterie.

☞L'un des objectifs essentiels de la présente invention est de fournir un procédé économique de mesure, in situ, en ligne et en temps réel, de la variation d'entropie d'une batterie, c'est-à-dire dans des conditions plus proches de l'utilisation normale de la batterie.

☞L'un des objectifs essentiels de la présente invention est de fournir un procédé simple et efficace du diagnostic de l'état de charge et/ou de l'état de santé des batteries, à partir de la variation d'entropie mesurée par le procédé visé dans les objectifs ci-dessus.

☞L'un des objectifs essentiels de la présente invention est de fournir un dispositif simple et performant pour la mise en Œuvre du procédé visé dans les objectifs ci-dessus.

### Brève description

Ces objectifs, parmi d'autres, sont atteints par la présente invention qui concerne en premier lieu, un procédé de mesure en ligne et in situ, de la variation d'entropie $\Delta S$ d'au moins une batterie, caractérisé en ce qu'il consiste essentiellement à :

(Phase I) Réaliser une modélisation préalable de la batterie dont l'état de charge (SOC : "State Of Charge") est compris entre 0 et 100% par mise en oeuvre des étapes suivantes:

(a) charger au moins partiellement la batterie avec un signal *Sc* de courant de charge ;
(b) et/ou décharger au moins partiellement la batterie avec un signal *Sd* de courant de décharge ;
(c) Mesurer des variables réelles utiles dans les étapes suivantes ;
(d) Modéliser le comportement électrique de la batterie pendant la charge (a) avec un signal *Sc* de courant de charge et/ou la décharge (b) avec un signal *Sd* de courant de décharge, pour estimer des paramètres électriques de la batterie ;
(e) Estimer périodiquement, à une fréquence Fe, des paramètres électriques de la batterie ;
(f) Modéliser le comportement thermique de la batterie pendant la charge (a) avec un signal *Sc* de courant de charge et/ou la décharge (b) avec un signal *Sd* de courant de décharge, pour estimer in-situ, en ligne et en temps réel, au moins l'un des paramètres du modèle thermique, à savoir ∆S ;
(g) Estimer périodiquement, à une fréquence Fg, au moins l'un des paramètres du modèle thermique, en particulier ∆S, en utilisant au moins l'un des paramètres électriques estimés à l'étape (e) ;

(Phase II) Mesurer des données thermodynamiques, en particulier *∆S,* de la batterie en cours d'utilisation dans une application et à un état de charge quelconque, en mettant en oeuvre les modèles électrique [étape (d)] et thermique [étape (f)] de la phase I, l'estimation des paramètres électriques [étape (e)] et l'estimation d'au moins l'un des paramètres du modèle thermique, en particulier *∆S* [étape (g)];
(Phase III) Eventuellement stocker les données mesurées/calculées lors de la phase II et /ou de la phase I,
Le procédé étant essentiellement tel que :

→ La modélisation de l'étape (d) consiste à considérer que la batterie est un circuit électrique ou modèle électrique comprenant une résistance $R_0$, une tension en circuit ouvert *OCV,* et un circuit $R_1C_1$ en série ;

le comportement électrique de la batterie étant décrit, dans ce modèle, par les équations suivantes :

$$\begin{cases} \dot{U}_1 & = & -\frac{1}{C_1 R_1} U_1 + \frac{1}{C_1} I \qquad (1) \\ V_{bat} & = & OCV + U_1 + R_0 I \qquad (2) \end{cases}$$

où $U_1$ est la tension aux bornes du circuit RC, *I* est le courant traversant la batterie et $V_{bat}$ la tension aux bornes de la batterie.
l'équation (2) étant discrétisée comme suit :

$$V_{bat,k} = I_k b_{0,\mathrm{k}} + I_{k-1} b_{1,\mathrm{k}} + a_{1,\mathrm{k}}(OCV_{k-1} - V_{bat,k-1}) + OCV_k \qquad (2')$$

et réécrite ainsi :

$$V_{bat,k} = \Theta_k^T \Phi_k \qquad (2'')$$

avec :

$$\begin{cases} \Theta_k^T & = & [b_{0,k} \quad b_{1,k} \quad a_{1,k} \quad OCV_k] \\ \Phi_k^T & = & [I_k \quad I_{1,k-1} \quad (OCV_{k-1} - V_{bat,k-1}) \qquad ] \end{cases}$$

où :

$$\begin{cases} b_0 & = & R_0 \\ \\ b_1 & = & -R_0 + \dfrac{T_s}{C_1} + \dfrac{T_s R_0}{C_1 R_1} \\ \\ a_1 & = & \dfrac{T_s}{C_1 R_1} - 1 \end{cases}$$

$T_s$ est la période d'échantillonnage du signal $S_e$ ;

$\Theta_k^T$ est le vecteur paramètres ;

-> La modélisation de l'étape (f) consiste à considérer la batterie comme un modèle thermique dans lequel la batterie, d'une part, est soumise à un courant $Sc$ de charge apte à être soumis à un échantillonnage ou à un courant $Sd$ de décharge apte à être soumis à un échantillonnage, et, d'autre part, est un échangeur de chaleur avec son environnement et dans lequel le comportement thermique de la batterie est décrit par l'équation suivante :

$$mC_p \frac{dT_{bat}}{dt} = I(V_{bat} - OCV) + IT_{bat}\frac{\Delta S}{F} + hA(T_{bat} - T_{amb}) \tag{3}$$

où :

- $m$ est la masse de la batterie
- $C_p$ est la capacité calorifique de la batterie
- $T_{bat}$ est la température de la batterie
- $t$ est la variable temps
- $I$ est le courant traversant la batterie
- $V_{bat}$ est la tension aux bornes de la batterie
- $OCV$ est la tension en circuit ouvert de la batterie
- $\Delta S$ est la variation d'entropie de la batterie
- $F$ est la constante de Faraday
- $h$ est le coefficient d'échange thermique avec l'extérieur
- $A$ est l'aire de la batterie en contact l'extérieur
- $T_{amb}$ est la température du milieu extérieur

l'équation (3) étant discrétisée comme suit :

$$T_{bat,k} - T_{bat,k-1} = a_{0,k}[I_k(V_{bat,k} - OCV_k)] + a_{1,k}I_k T_{bat,k} + a_{2,k}(T_{bat,k} - T_{amb,k}) \tag{4}$$

et réécrite ainsi :

$$T_{bat,k} - T_{bat,k-1} = \Theta_k^T \Phi_k \tag{5}$$

avec :

$$\begin{cases} \Theta_k^T & = & [a_{0,k} \quad a_{1,k} \quad a_{2,k}] \\ \\ \Phi_k & = & [I_k(V_{bat,k} - OCV_k) \quad I_k T_{bat,k} \quad T_{bat,k} - T_{amb,k}] \end{cases}$$

où :

$$\begin{cases} a_0 & = & \dfrac{T_s}{mC_p} \\[2ex] a_1 & = & \dfrac{T_s\Delta S}{mC_pF} \\[2ex] a_2 & = & \dfrac{T_s hA}{mC_p} \end{cases} \text{soit} \begin{cases} mC_p & = & \dfrac{T_s}{a_0} \\[2ex] \Delta S & = & \dfrac{a_1 F}{a_0} \\[2ex] hA & = & \dfrac{a_2}{a_0} \end{cases}$$

$T_s$ est la période d'échantillonnage de mesure.

Ce procédé permet donc d'estimer un grand nombre de paramètres de la batterie considérée, il permet notamment d'estimer la force électromotrice (tension en circuit ouvert « Open Circuit Voltage-*OCV* », la variation d'entropie *ΔS* et donc la variation d'enthalpie *ΔH*. Au-delà de ces paramètres, ce procédé permet aussi d'estimer la résistance interne et la capacité calorifique de la batterie.

Ce procédé est particulièrement avantageux en ce qu'il permet de mesurer en ligne, en temps réel et in situ les paramètres d'une batterie en cours d'utilisation, par exemple dans un véhicule électrique.

Une fois, par exemple, la variation d'entropie estimée, il est possible d'estimer l'état de santé de la batterie, connaissance fondamentale pour une bonne gestion de la batterie.

C'est ainsi que dans un autre de ses aspects, la présente invention concerne un procédé de détermination de l'état de charge (SOC) et/ou de l'état de santé (SOH : "State Of Health") d'une batterie à partir de *ΔS* et/ou de *ΔH* mesuré par le procédé selon l'invention.

La présente invention concerne également un dispositif pour la mise en oeuvre du procédé de mesure de la variation d'entropie selon l'invention.

### Définitions

Dans tout le présent exposé, tout singulier désigne indifféremment un singulier ou un pluriel. Les définitions données ci-après à titre d'exemples, peuvent servir à l'interprétation du présent exposé :

- "*mesure des données thermodynamiques in situ*" : La mesure in-situ fait référence à une mesure pendant l'utilisation de la batterie dans une application, par exemple : batterie utilisée dans un véhicule électrique. Cela est en opposition avec une mesure qui aurait lieu dans un contexte de laboratoire.
- "*mesure des données thermodynamiques en ligne*" : La mesure en ligne est une mesure qui estime les paramètres ou les états d'un modèle [modèle électrique étape (d) ou modèle thermique étape (f)], quand de nouvelles données sont disponibles pendant l'utilisation de la batterie dans une application.
- "*batterie*" : dispositif électrochimique unitaire (cellule) comprenant deux électrodes séparées par un électrolyte ou assemblage d'accumulateurs connectés ensemble pour obtenir la capacité et la tension désirées.
- "*environ*" ou "*sensiblement*" signifie à plus ou moins 10 % près, voire plus ou moins 5% près, rapporté à l'unité de mesure utilisée.
- "*compris entre Z1 et Z2*" signifie que l'une et/ou l'autre des bornes Z1, Z2 est incluse ou non dans l'intervalle [Z1, Z2].

### Description détaillée

Cette description est faite en référence aux figures annexées dans lesquelles :

- La figure 1 est un schéma du modèle électrique mis en oeuvre à l'étape (d) du procédé selon invention.
- La figure 2 est un schéma de principe d'utilisation de 2 algorithmes RLS des moindres carrés récursifs dans les étapes (e) & (g) d'estimation périodique, respectivement.
- La figure 3 est un schéma du banc de test utilisé dans l'exemple de mise en oeuvre du procédé selon l'invention.
- La figure 4 du haut est une courbe montrant la réponse en température d'une batterie 18 650 au courant, dans l'exemple selon invention, en vue d'estimer *mCp* et *hA.*

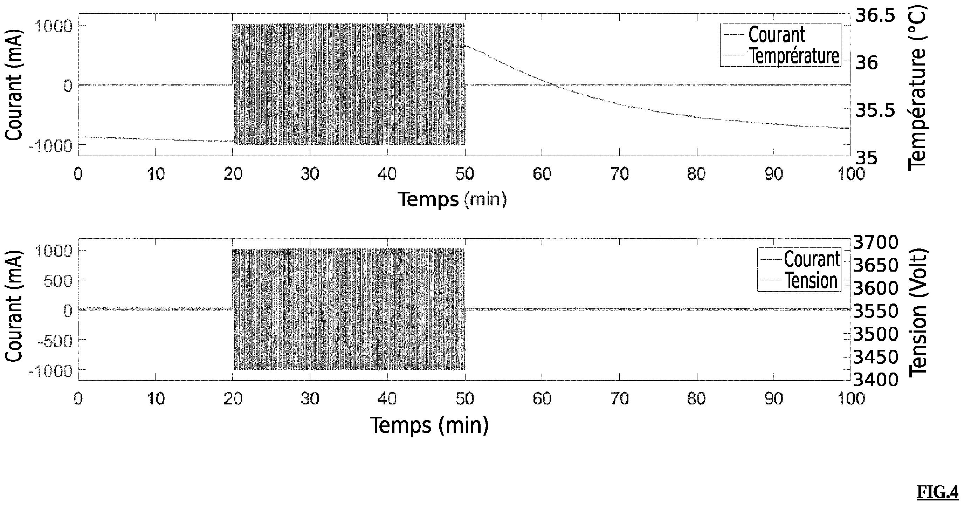

- La figure 4 du bas est une courbe montrant la réponse en tension d'une batterie 18 650 au courant, dans l'exemple selon invention, en vue d'estimer $mC_p$ et *hA.*

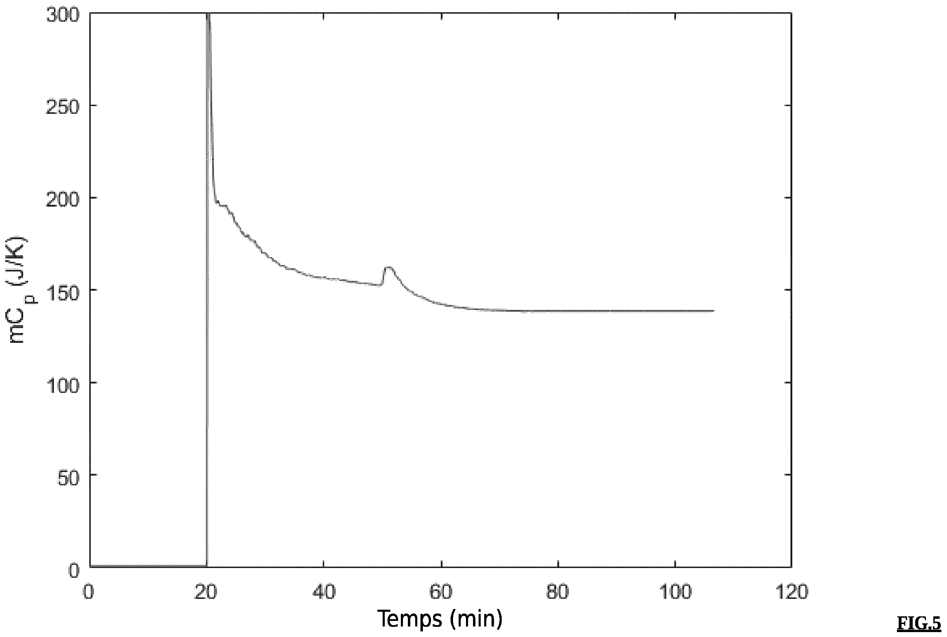

- La figure 5 est une courbe de l'estimation du paramètre $mC_p$ en fonction du temps.

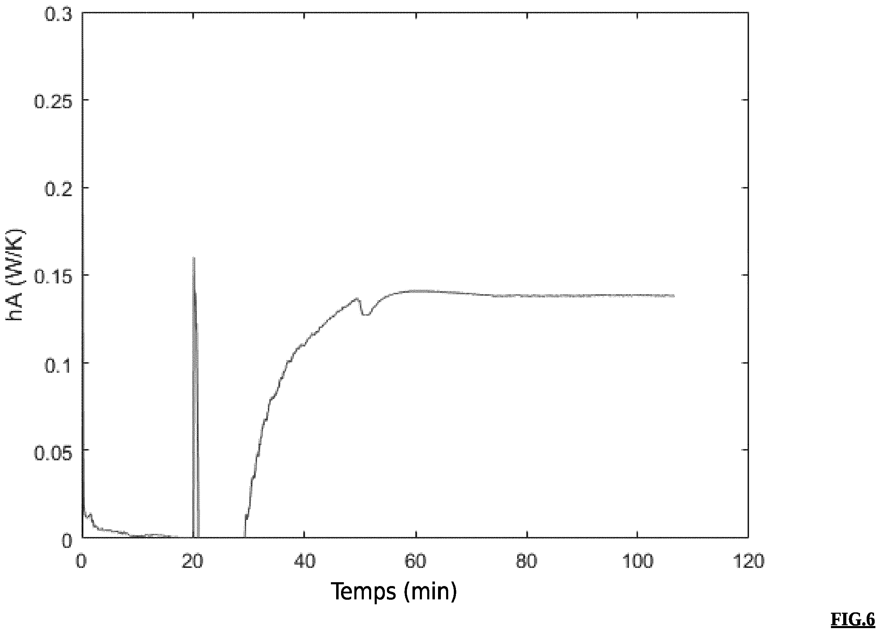

- La figure 6 est une courbe de l'estimation du paramètre *hA* en fonction du temps.

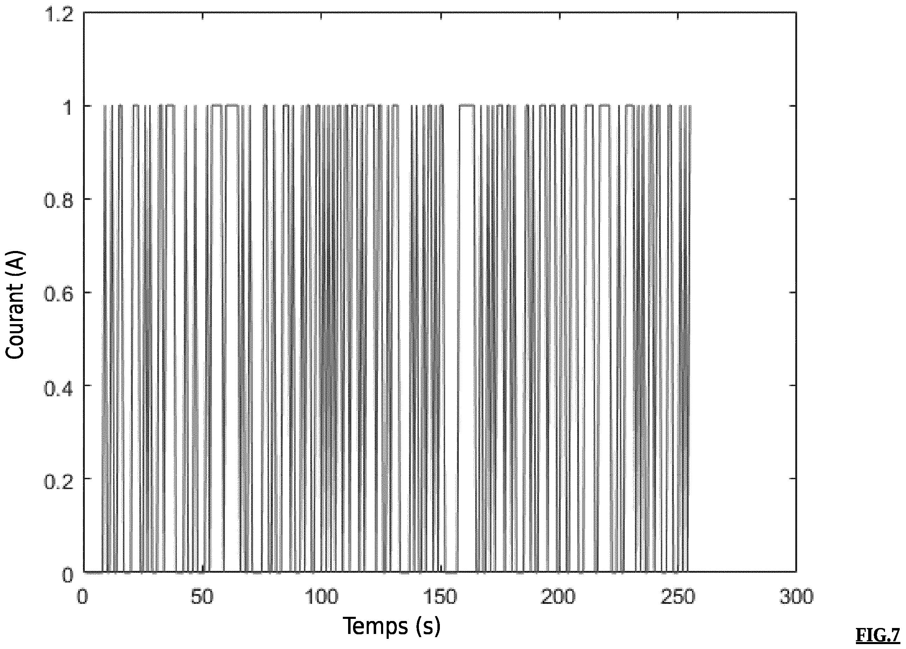

- La figure 7 montre le courant d'entrée Se ou de charge Sc constitué par un signal signal SBPA en A en fonction du temps (s).

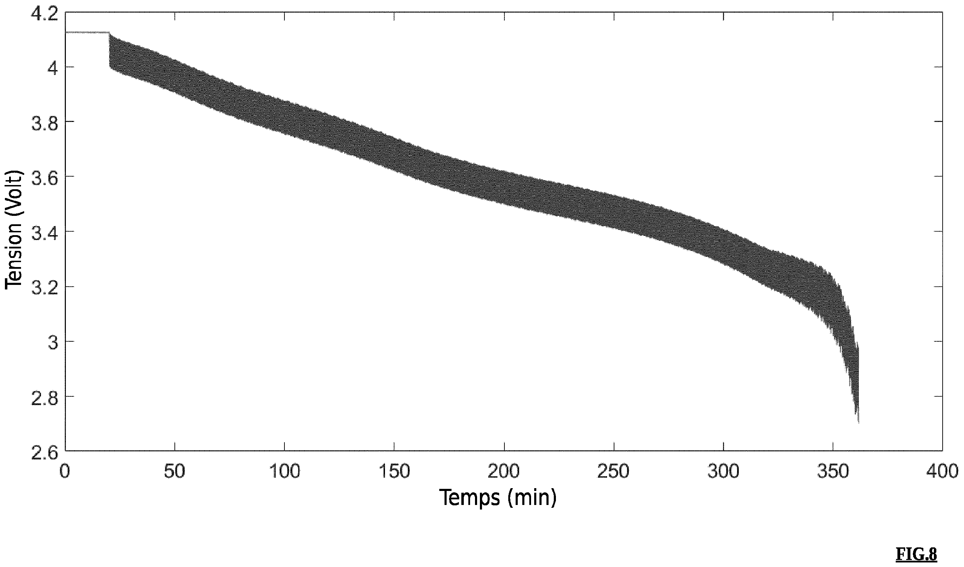

- La figure 8 montre la réponse en tension (V) d'une batterie 18650 au courant, dans l'exemple, en vue d'estimer $R_0$ et *OCV*.

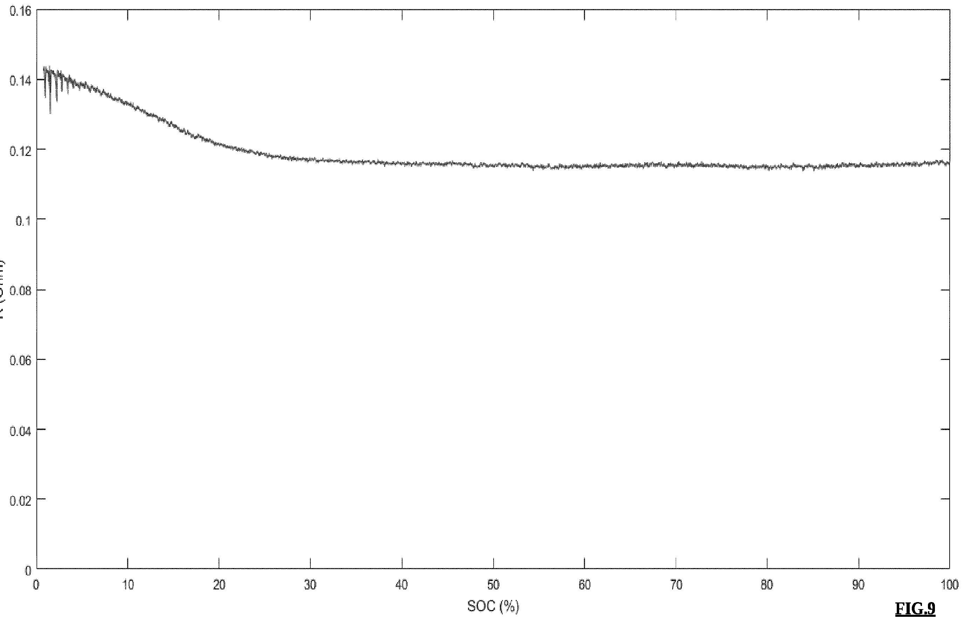

- La figure 9 montre une estimation de $R_0$ (ohms) en fonction de l'état de charge SOC (%) pendant la décharge.

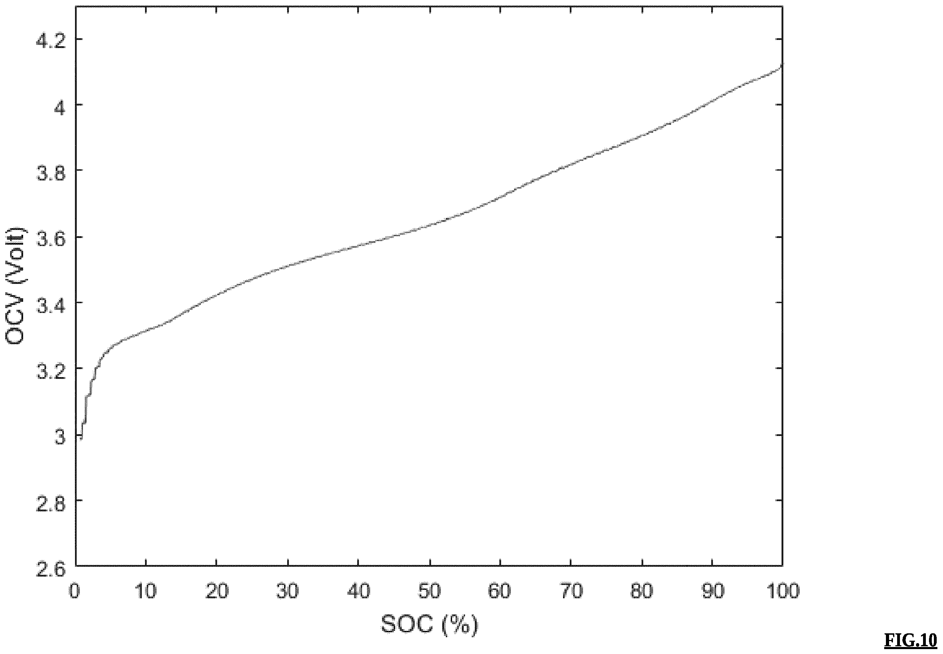

- La figure 10 montre une estimation de *OCV* (V) en fonction de l'état de charge *SOC* (%) pendant la décharge.

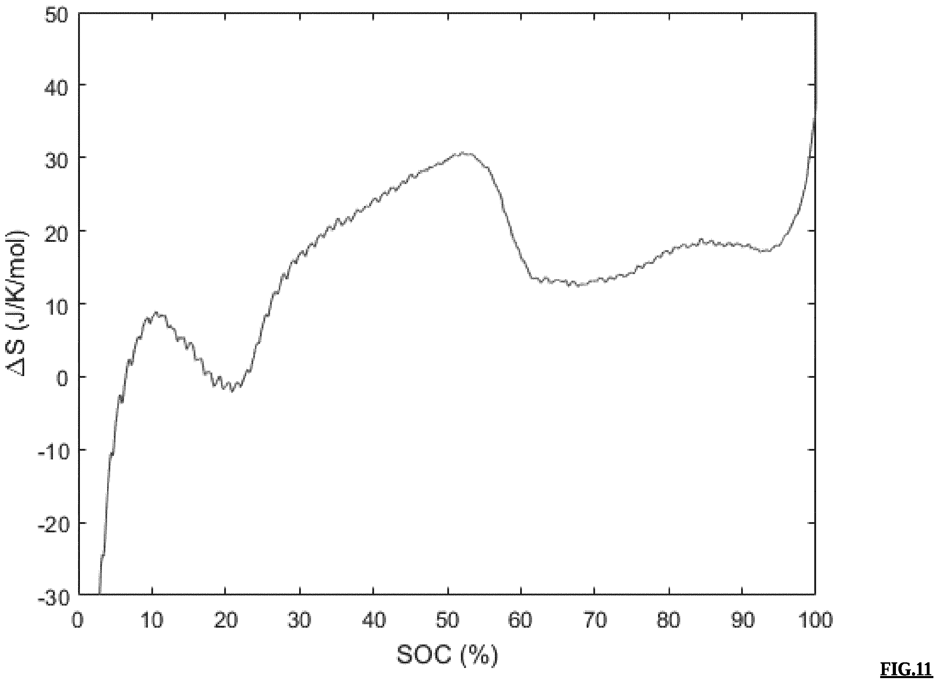

- La figure 11 est une courbe de *ΔS* (J/K/mol) en fonction de l'état de charge *SOC* (%) pendant la décharge.

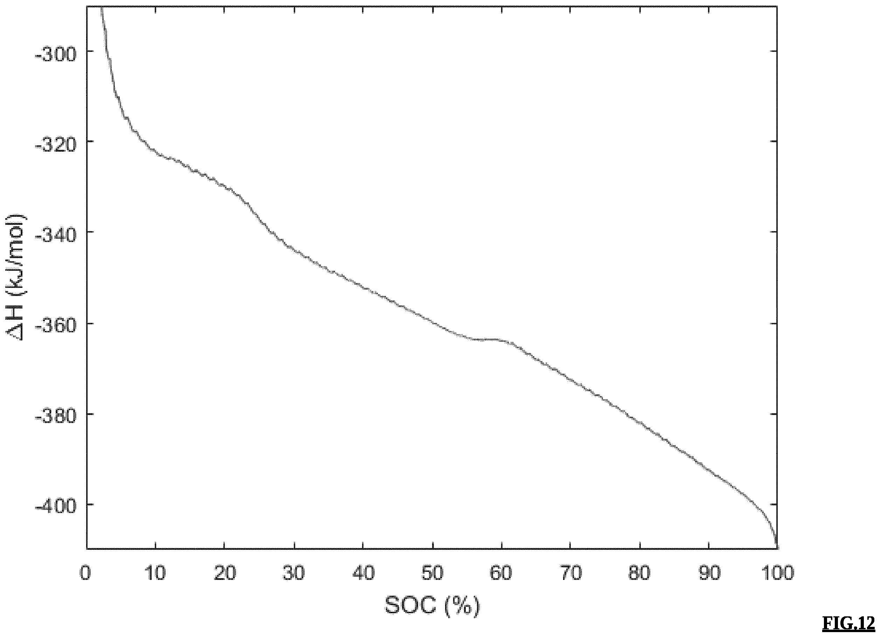

- La figure 12 est une courbe de *ΔH* (kJ/mol) en fonction de l'état de charge *SOC* (%) pendant la décharge.

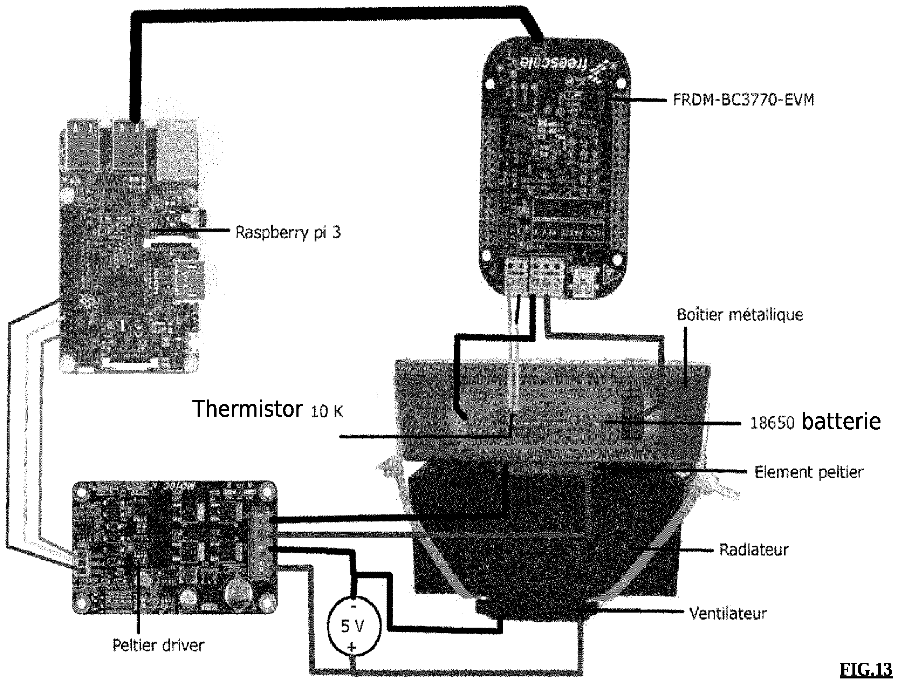

- La figure 13 montre le banc de test pour une mesure standard des données thermodynamiques dans l'exemple comparatif.

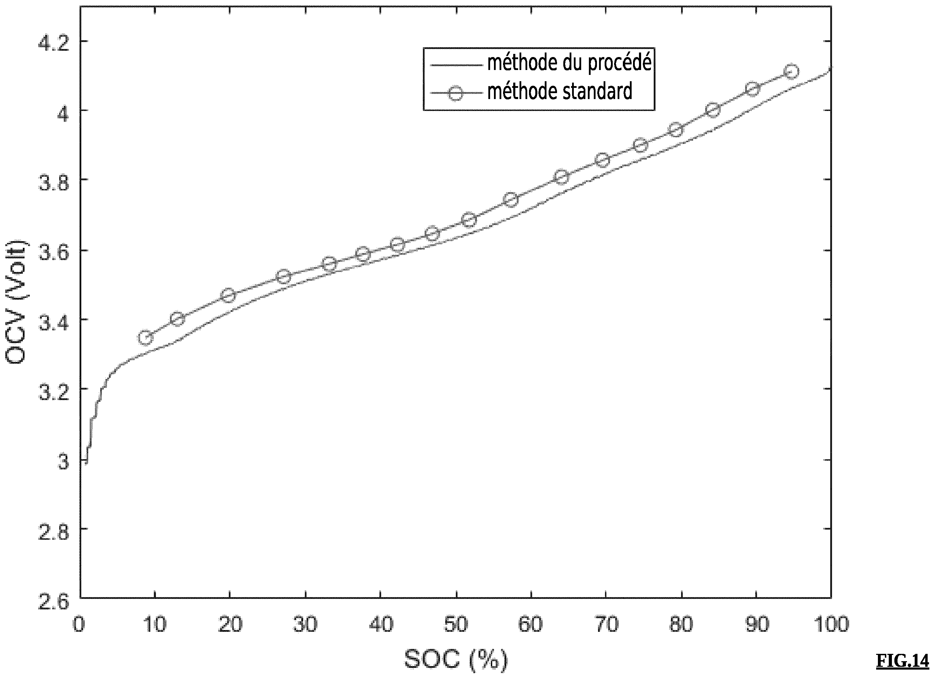

- La figure 14 montre des courbes comparatives des profils d'OCV(V) en fonction de l'état de charge *SOC* (%) obtenus par le procédé selon invention (« *online method* ») et par ETM dans l'exemple comparatif (standard method) en décharge.

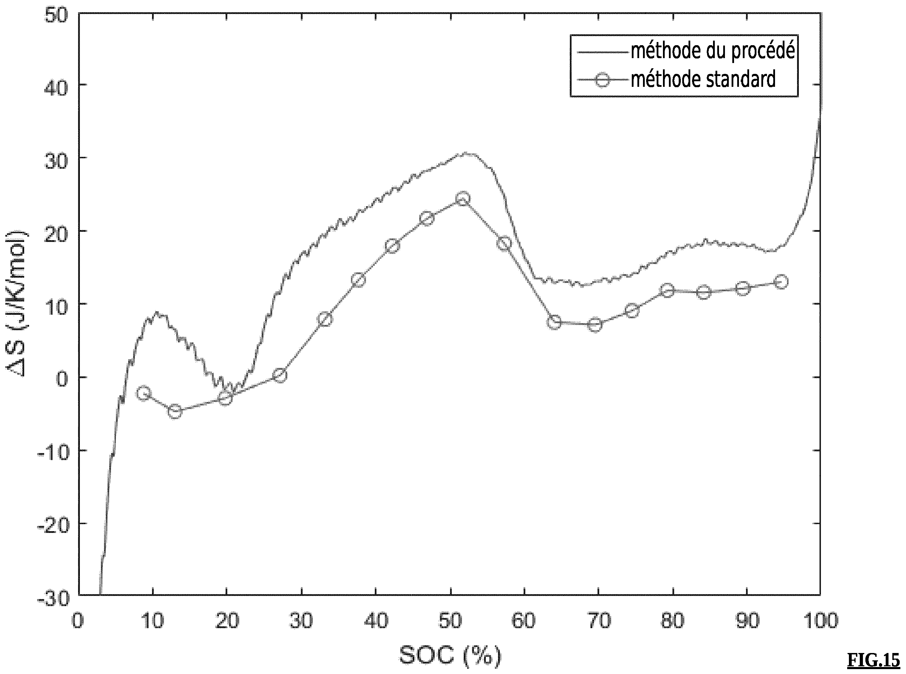

- La figure 15 montre des courbes comparatives des profils ΔS (J/K/mol) en fonction de l'état de charge *SOC* (%) obtenus par le procédé selon invention (online method) et par ETM dans l'exemple comparatif (standard method) en décharge.

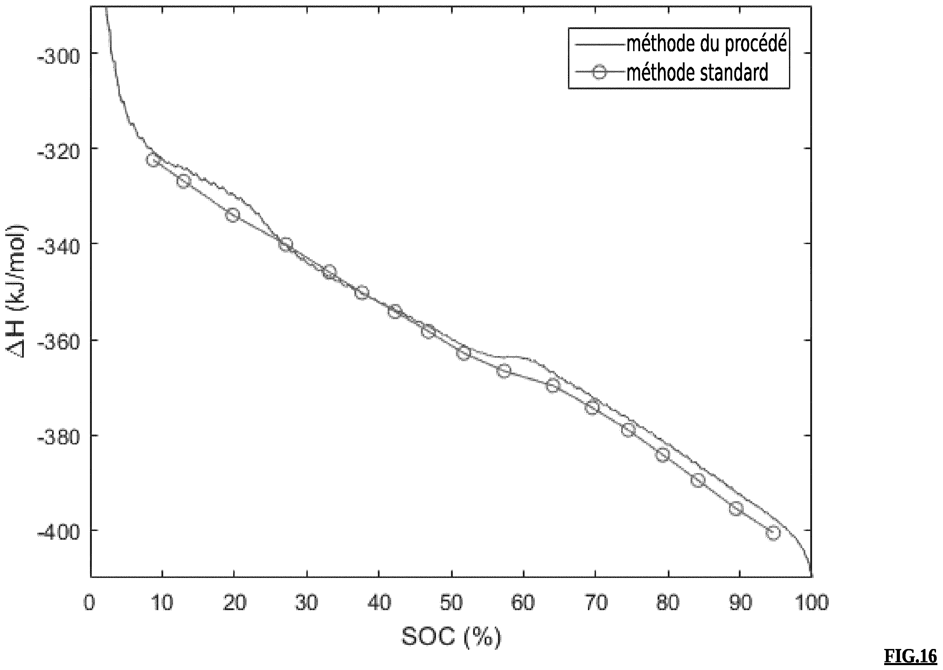

- La figure 16 montre des courbes comparatives des profils *ΔH* (kJ/mol) en fonction de l'état de charge *SOC* (%) obtenus par le procédé selon invention (online method) et par ETM dans l'exemple comparatif (standard method) en décharge.

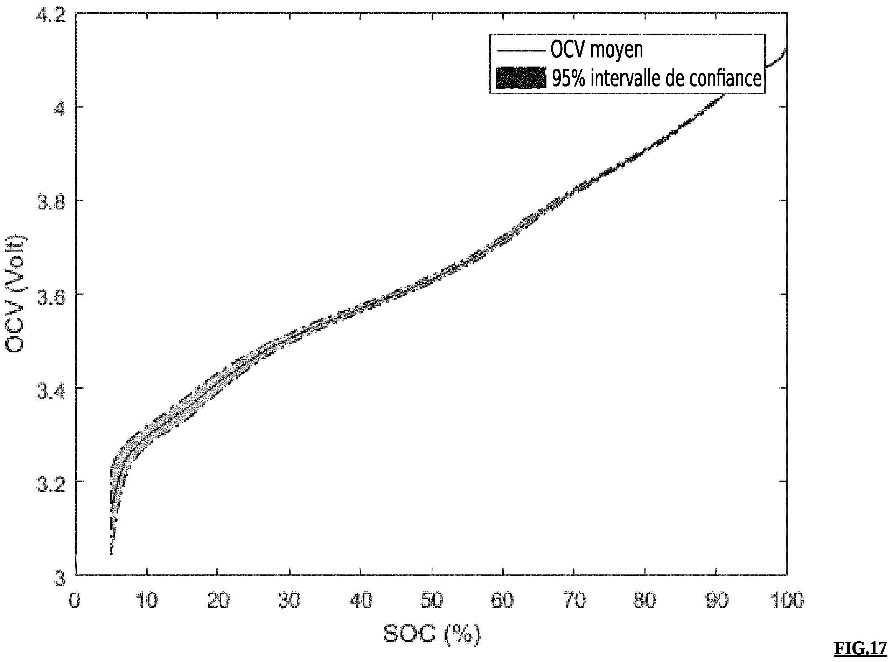

- La figure 17 montre des courbes d'OCV (V) en fonction de l'état de charge *SOC* (%) obtenus par le procédé selon invention, mesurées plusieurs fois dans les mêmes conditions.

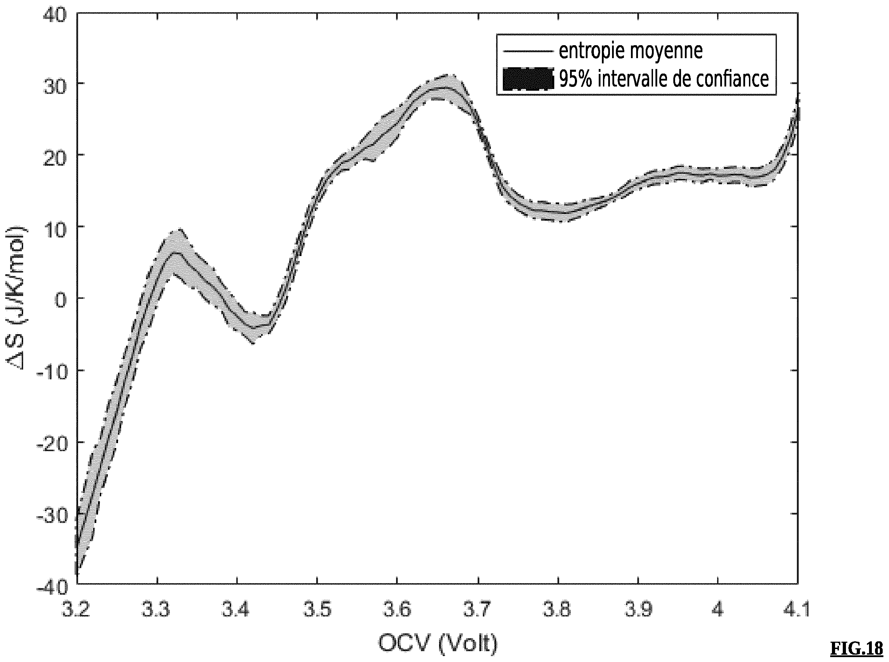

- La figure 18 montre des courbes *ΔS* (J/K/mol) en fonction d'OCV (V) obtenues par le procédé selon invention, mesurées plusieurs fois dans les mêmes conditions.

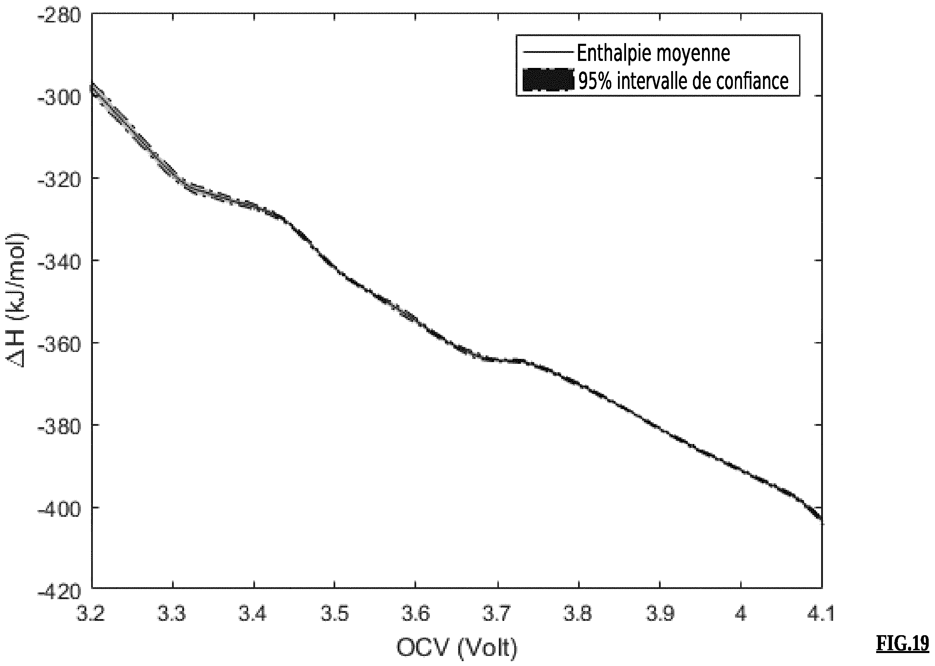

- La figure 19 montre des courbes *ΔH* (kJ/mol) en fonction d'OCV (V) obtenues par le procédé selon invention, mesurées plusieurs fois dans les mêmes conditions.

➢ PROCEDE DE MESURE DE LA VARIATION D'ENTROPIE *ΔS*

*PHASE I DE MODELISATION*

La phase I de modélisation du procédé selon invention comprend avantageusement les étapes suivantes :

*Etape ($a_0$) facultative mais néanmoins préférée : pré-estimation des paramètres $mC_p$ et hA*
*Etape (a) charge de la batterie avec un signal Sc de courant de charge*
*Etape (b) et/ou décharge de la batterie avec unsignal Sd de courant de_déçharge*
*Etape (c) mesure de variables réelles*
*Etape (d) modélisation électrique*
*Etape (e) estimation des pamètres électriques*
*Etqpe (f) modélisation thermique*
*Etape (g) estimation des paramètres thermodynamiques*

Pour les modélisations (d) et (f), l'étape (a) de charge et/ou l'étape (b) de décharge s'opère(nt) parallèlement, c'est-à-dire simultanément, aux étapes (c) à (g).
Dans un mode de mise en oeuvre comprenant une étape (b) de décharge au moins partielle pendant laquelle les étapes (c) à (g) sont mises en oeuvre, on prévoit auparavant, conformément à l'invention, une étape (a) de charge totale de la batterie.
Suivant une variante de ce mode de mise en oeuvre, l'étape (a) préalable est une charge partielle de la batterie.
Dans un autre mode de mise en oeuvre comprenant une étape (a) de charge pendant laquelle les étapes (c) à (g) sont mises en oeuvre, on prévoit auparavant, conformément à l'invention, une étape (b) de décharge totale de la batterie.
Suivant une variante de ce mode de mise en oeuvre, l'étape (b) préalable est une décharge partielle de la batterie.
Indépendamment de leur référencement alphabétique croissant, les étapes (c) à (g) ne sont pas nécessairement successives.

*Modèle thermo-électrique [Etapes (d) & (f)]*

L'approche retenue par l'invention pour estimer des données thermodynamiques d'une batterie consiste à choisir une représentation thermoélectrique simple du système comprenant la batterie.
Cette représentation thermoélectrique, qui a également l'avantage de pouvoir être appliquée à une grande variété de batteries, est composée d'un modèle électrique [Etape (d)] et d'un modèle thermique [Etape (f)].

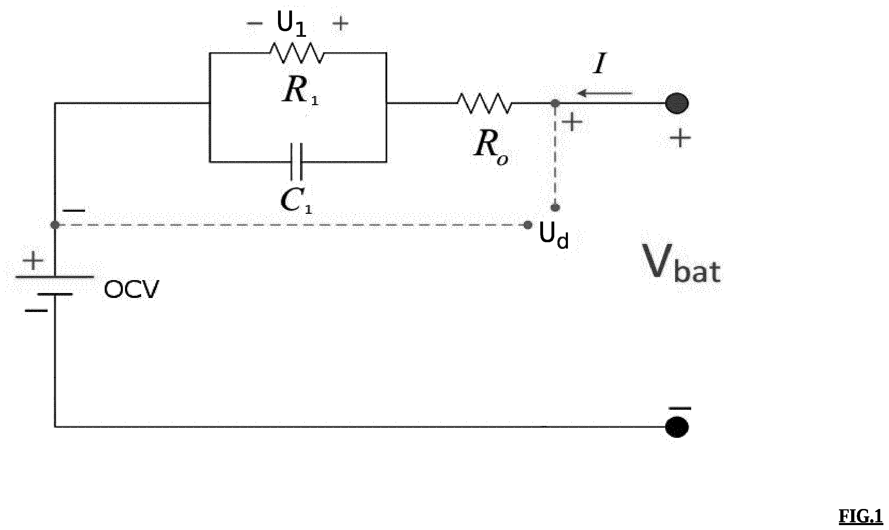

- Le modèle électrique permet d'estimer les paramètres électriques de la batterie tels que la résistance interne et la force électromotrice. Il est avantageusement basé sur le modèle dit « modèle de Thévenin » qui considère la batterie comme une résistance en série avec un circuit RC. Comme montré sur la figure 1, ce modèle consiste en une résistance $R_0$, une tension en circuit ouvert $OCV$ est un circuit $R_1 C_1$ en série.

Dans ce modèle, le comportement électrique de la batterie est décrit aussi par les équations suivantes :

$$\begin{cases} \dot{U}_1 & = & -\frac{1}{C_1 R_1} U_1 + \frac{1}{C_1} I & (1) \\ \\ V_{bat} & = & OCV + U_1 + R_0 I & (2) \end{cases}$$

où $U_1$ est la tension aux bornes du circuit RC, $I$ est le courant traversant la batterie et $V_{bat}$ la tension aux bornes de la batterie.

Les équations sont ensuite discrétisées de la même manière que dans "V.-H. Duong, H. A. Bastawrous, K. Lim, K. W. See, P. Zhang, and S. X. Dou, "Online state of charge and model parameters estimation of the LiFePO4 battery in electric vehicles using multiple adaptive forgetting factors recursive least-squares," JOURNAL Of POWER SOURCES, vol. 296, pp. 215-224, Nov 20 2015". On obtient:

$$V_{bat,k} = I_k b_{0,k} + I_{k-1} b_{1,k} + a_{1,k}(OCV_{k-1} - V_{bat,k-1}) + OCV_k \qquad (2')$$

qui peut se réécrire:

$$V_{bat,k} = \Theta_k^T \Phi_k \qquad (2'')$$

avec:

$$\begin{cases} \Theta_k^T & = & [b_{0,k} \quad b_{1,k} \quad a_{1,k} \quad OCV_k] \\ \\ \Phi_k^T & = & [I_k \quad I_{k-1} \quad (OCV_{k-1} - V_{bat,k-1}) \quad \;] \end{cases}$$

où:

$$\begin{cases} b_0 & = & R_0 \\ \\ b_1 & = & -R_0 + \frac{T_s}{C_1} + \frac{T_s R_0}{C_1 R_1} \\ \\ a_1 & = & \frac{T_s}{C_1 R_1} - 1 \end{cases}$$

$T_s$ est la période d'échantillonnage. $\Theta_k^T$ est le vecteur paramètres, en identifiant ce vecteur il est alors possible d'estimer une valeur de $R_0$ et $OCV$.

Conformément à une disposition préférée de mise en oeuvre de l'invention, $OCV$ est utilisé dans le modèle thermique.

- Le modèle thermique permet d'estimer avec précision les paramètres thermodynamiques de la batterie tels que la variation d'entropie et ce, en continu et sans contrôle spécifique des conditions d'utilisation.

Ce modèle thermique est fondé notamment sur le fait que la chaleur dégagée ou absorbée par la batterie provient principalement de 2 phénomènes :

- L'effet joule et la variation d'entropie. En effet, la batterie ayant une résistance interne, elle produit de la chaleur lorsque le courant passe, en charge ou décharge.
- Par ailleurs, la chaleur peut être absorbée ou émise selon le signe de la variation d'entropie et du courant traversant la batterie. Un échange de chaleur se produit également entre la batterie et son environnement.

La modélisation de l'étape (f) consiste à considérer la batterie comme un modèle thermique dans lequel la batterie, d'une part, est soumise à un courant $Sc$ de charge apte à être soumis à un échantillonnage ou à un courant $Sd$ de décharge apte à être soumis à un échantillonnage, et, d'autre part, est un échangeur de chaleur avec son environnement et dans lequel le comportement thermique de la batterie est décrit par l'équation suivante :

$$mC_p \frac{dT_{bat}}{dt} = I(V_{bat} - OCV) + IT_{bat}\frac{\Delta S}{F} + hA(T_{bat} - T_{amb}) \qquad (3)$$

où :

- m est la masse de la batterie
- $C_p$ est la capacité calorifique de la batterie
- $T_{bat}$ est la température de la batterie
- $t$ est la variable temps
- $I$ est le courant traversant la batterie
- $V_{bat}$ est la tension aux bornes de la batterie
- $OCV$ est la tension en circuit ouvert de la batterie
- $\Delta S$ est la variation d'entropie de la batterie
- $F$ est la constante de Faraday
- $h$ est le coefficient d'échange thermique avec l'extérieur
- $A$ est l'aire de la batterie en contact l'extérieur
- $T_{amb}$ est la température du milieu extérieur

L'équation (3) est ensuite discrétisée :

$$T_{bat,k} - T_{bat,k-1} = a_{0,k}[I_k(V_{bat,k} - OCV_k)] + a_{1,k}I_kT_{bat,k} + a_{2,k}(T_{bat,k} - T_{amb,k}) \quad (4)$$

qui peut se réécrire:

$$T_{bat,k} - T_{bat,k-1} = \Theta_k^T \Phi_k \qquad (5)$$

avec:

$$\begin{cases} \Theta_k^T &= \qquad\qquad [a_{0,k} \quad a_{1,k} \quad a_{2,k}] \\ \Phi_k^T &= [I_k(V_{bat,k} - OCV_k) \quad I_kT_{bat,k} \quad T_{bat,k} - T_{amb,k}] \end{cases}$$

où:

$$\begin{cases} a_0 & = & \dfrac{T_s}{mC_p} \\[2em] a_1 & = & \dfrac{T_s \Delta S}{mC_p F} \\[2em] a_2 & = & \dfrac{T_s hA}{mC_p} \end{cases} \text{soit} \begin{cases} mC_p & = & \dfrac{T_s}{a_0} \\[2em] \Delta S & = & \dfrac{a_1 F}{a_0} \\[2em] hA & = & \dfrac{a_2}{a_0} \end{cases}$$

$T_s$ est la période d'échantillonnage de mesure.

Dans une variante, $R$ peut être utilisé à la place ou en complément de $OCV$ dans le modèle thermique.

Les deux modèles proposés peuvent s'écrire comme une combinaison linéaire de grandeurs mesurées. On peut donc appliquer des algorithmes tels que celui des moindres carrés pour estimer les coefficients de cette combinaison linéaire et donc les paramètres.

Cette méthode permet donc d'estimer un grand nombre de paramètres de la batterie considérée, elle permet d'estimer la force électromotrice, la variation d'entropie et donc la variation d'enthalpie. Au-delà de ces paramètres, cette méthodologie permet aussi d'estimer, entre autres, la résistance interne, la capacité calorifique de la batterie, l'état de charge et l'état de santé de la batterie.

*Etape ($a_0$) facultative mais néanmoins préférée : pré-estimation des paramètres $mC_p$ et $hA$*

Dans un mode préféré de mise en oeuvre de l'invention, les produits $mC_p$ et $hA$ sont considérés comme constants par rapport à l'état de charge et l'état de santé de la batterie.

Il est donc avantageux d'estimer ces deux paramètres une fois pour toutes et d'utiliser ces valeurs dans le modèle électrique suivant l'invention, pour une batterie donnée.

Cette pré-estimation consiste essentiellement à :

- Mettre en oeuvre une relaxation d'une durée (variable selon les batteries) comprise entre 10 min et 60 min de la batterie afin que le paramètre $OCV$ de l'équation (0) du modèle électrique, ait une valeur donnée précise ;
- Appliquer un signal électrique d'entrée $S_e$ périodique dont la période est choisie de telle sorte que la moyenne de la chaleur générée par $\Delta S$ sur une période soit de l'ordre de 0, $S_e$ étant de préférence un signal carré de période comprise entre 10 et 30 secondes, idéalement de l'ordre de 20 secondes, ce signal carré étant plus préférentiellement encore de moyenne nulle ;
- Estimer les produits $mC_p$ et $hA$, de préférence au moyen d'un algorithme des moindres carrés récursifs, grâce à l'équation (3) devenue l'équation (3') suivante:

$$mC_p \frac{dT_{bat}}{dt} = I(V_{bat} - OCV) + hA(T_{bat} - T_{amb}) \qquad (3')$$

et par mesure des variables réelles correspondant aux paramètres $V_{Bat}$, $I$, $T_{bat}$, $T_{amb}$;
- intégrer cette estimation des produits $mC_p$ et $hA$ dans le modèle thermique pour les étapes (f) & (g).

La période de relaxation de la tension de la batterie peut être d'une dizaine de minutes On a ainsi une valeur de OCV précise.

On utilise ensuite de préférence un algorithme des moindres carrés récursifs (algorithme RLS), pour estimer ces deux paramètres.

*Etape (a) charge de la batterie avec un signal Sc de courant de charge*

Pour la mise en oeuvre de l'étape (a) de charge, on applique, de manière répétitive, un courant de charge $Sc$, dont la gamme de fréquences est comprise entre 0 et 1 Hz, de préférence un signal correspondant à une Séquence Binaire Pseudo Aléatoire -SBPA-, choisi de telle sorte que le "C rate" (C: capacité de la batterie) de la batterie soit compris entre 0,01.C et 3.C, de préférence entre 0,1.C et 2,5.C, et, plus préférentiellement encore entre 0,2.C et 2.C.

Cela peut correspondre par exemple, pour une batterie au lithium donnée, à un courant de charge Sc, dont l'intensité est par exemple comprise entre 0 et 1A.

Selon une modalité avantageuse de l'invention, le courant de charge $Sc$ est échantillonné toutes les secondes.

*Etape (b) Décharge de la batterie avec un signal Sd de courant de décharge*

Pour la mise en oeuvre de l'étape (b) de décharge, on applique, de manière répétitive, un courant de décharge *Sd,* dont la gamme de fréquences est comprise entre 0 et 1 Hz, de préférence un signal correspondant à une Séquence Binaire Pseudo Aléatoire -SBPA, choisi de telle sorte que le "C rate" (C: capacité de la batterie) de la batterie soit compris entre 0,01.C et 3.C, de préférence entre 0,1.C et 2,5.C, et, plus préférentiellement encore entre 0,2.C et 2.C.

Cela peut correspondre par exemple, pour une batterie au lithium donnée, à un courant de décharge *Sd,* dont l'intensité est par exemple comprise entre 0 et -1A.

Selon une modalité avantageuse de l'invention, le courant de décharge *Sd* est échantillonné toutes les secondes.

*Etape (c) mesure de variables réelles*

Les variables réelles mesurées à l'étape (c) correspondent avantageusement aux paramètres, $V_{Bat}$ , $I$, $T_{bat}$ , $T_{amb}$ des modèles électrique et thermique.

*Etape (d) modélisation électrique / Etape (f) modélisation thermique*

Confer supra.

*Etape (e) estimation des paramètres électriaues /Etape (g) estimation des paramètres thermodynamiques*

Suivant une caractéristique remarquable de l'invention, l'étape (e) est réalisée au moyen d'un algorithme des moindres carrés récursifs et l'estimation selon l'étape (g) est réalisée au moyen d'un algorithme des moindres carrés récursifs.

Pour l'estimation des paramètres électriques de l'étape (e), on charge et on décharge la batterie conformément aux étapes (a) & (b).

Les paramètres du modèle électrique de préférence pris en compte sont $R_0$ et *OCV*. $R_0$ est un paramètre utilisé pour une estimation du vieillissement de la batterie. *OCV* est utile pour le modèle thermique, pour estimer $\Delta S$.

On applique ensuite l'algorithme RLS aux données pour estimer les paramètres du modèle. Les paramètres sont mis à jour toutes les 0,2 secondes.

Pour l'estimation de $\Delta S,$ on applique de préférence l'algorithme RLS sur les données liées au modèle thermique.

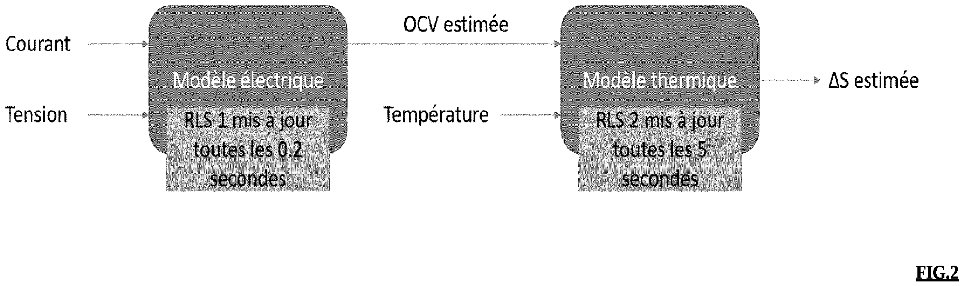

Comme montré sur la figure 2, deux algorithmes RLS travaillent en même temps. Le premier, comme dit précédemment va estimer *OCV* à partir du courant et de la tension. Cette estimation va être utilisée par un deuxième algorithme RLS basé sur le modèle thermique et utilisant la température en vue d'estimer $\Delta S$. Il est à noter que la dynamique électrique étant bien plus rapide que la dynamique thermique, la fréquence utilisée pour mettre à jour les paramètres électriques est plus élevée que pour les paramètres thermiques.

On peut aussi obtenir une estimation de l'enthalpie $\Delta H$ à partir de *OCV* et $\Delta S$ de la manière suivante:

$$\Delta H = -F.OCV - T_{bat}\Delta S \tag{6}$$

On effectue ainsi l'estimation du paramètre électrique *OCV* et des paramètres thermodynamiques ( $\Delta S$ et $\Delta H$) en temps réel avec un algorithme récursif.

Dans un autre de ses aspects, l'invention vise un procédé de détermination de l'état de charge et/ou de l'état de santé d'une batterie à partir de $\Delta S$ et/ou de $\Delta H$.

- Pour l'estimation du SOC : Il est démontré que pour une valeur donnée du SOC, correspond un couple unique de valeur ($\Delta S$ et $\Delta H$). Si ces derniers sont estimés, alors le SOC peut également l'être, d'où l'importance d'une estimation temps réel. Une mise en oeuvre simple est l'estimation du SOC en concidérant ce dernier comme une combinaison linéaire de $\Delta S$ et $\Delta H$. Le SOC peut s'écrire **SOC**(%)= $\alpha \Delta S$+ $\beta \Delta H$ + $\gamma$ avec $\alpha$, $\beta$ et $\gamma$ des paramètres à déterminer pour une batterie donnée. Pour déterminer ces dernières, les grandeurs thermodynamiques $\Delta S$ et $\Delta H$ sont mesurés pour une batterie donnée de 0 à 100%. On détermine ensuite la relation entre $\Delta S$, $\Delta H$ et SOC tel que **SOC**(%)= $\alpha \Delta S$+ $\beta \Delta H$ + $\gamma$. $\alpha$, $\beta$ et $\gamma$ sont déterminés préférentiellemnt par la méthode des moindres carrés. Pour un exemple d'un tel procédé, on peut se référer à la demande de brevet US2016146895A1.
- Pour l'estimation du SOH, il est possible d'estimer un indicateur SOH basé sur l'énergie d'une batterie à partir de ses profils thermodynamiques grâce à des outils de « machine leaming».

Par exemple, des cellules éléctrochimiques Lithium-ion de type 18650 (hauteur : 65 mm et diamètre 18 mm) subissent un vieillisement par cyclage (charge-décharge successifs). Le vieillisement des cellules ont été effectués à 1.5 C-rate et à 55°C. On mesure à différents stades de vieillissement, un indicateur SOH basé sur l'énergie de la batterie et différentes grandeurs thermodynamiques. Ces dernières sont mesurées par la méthode standard ETM. Il a été possible d'établir par la suite un lien entre une des grandeurs thermodynamiques, $\Delta S$ en l'occurrence, et l'indicateur SOH basé sur l'énergie avec des outils de « machine leaming » . Un exemple d'algorithme de machine learning utilisé pour les relier est la régression linéaire multiple. L'indicateur SOH est ici estimé comme une combinaison linéaire de $\Delta S$ à certaines valeurs de SOC ou OCV.

Selon un mode de mise en oeuvre, la mise en oeuvre de l'étape (e) permet d'estimer, à une fréquence Fe comprise entre 0 et 10 Hz, de préférence de l'ordre de 1 Hz, $R0$ et $OCV$ en fonction de l'état de charge de la batterie.

Selon un mode de mise en oeuvre et en ce que la mise en oeuvre de l'étape (g) permet d'estimer, à une fréquence Fg comprise entre 0 et 1Hz, de préférence de l'ordre de 0.2 Hz, $\Delta S$ en fonction de l'état de charge de la batterie,

*PHASE 11 DE MESURE*

Cette phase II de mesure in situ, en cours d'utilisation de la batterie dans une application donnée, par exemple alimentation d'un véhicule électrique, se déroule après la phase I de modélisation théorique.

Le procédé est généralement interrompu pendant un certain temps entre la phase I et la phase II.

*PHASE III DE STOCKAGE*

Cette phase III facultative de stockage des données mesurées/calculées lors de la phase II s'opère de préférence simultanément à cette phase II.

Selon une variante, ces données peuvent être (télé)transmises par tous moyens appropriés un centre d'analyse et de traitement.

Les données recueillies in situ peuvent être utilisées à l'amélioration de la modélisation.

➢ DISPOSITIF DE MISE EN ŒUVRE

i. Chargeur/déchargeur : il s'agit d'un élément capable de charger et de décharger la batterie de manière programmable. Dans un exemple de réalisation, ce chargeur/déchargeur est un module de d'évaluation FRDM-BC3770-EVM de la compagnie NXP. Le courant maximal de charge est de 2 A et de décharge 1 A. Le chargeur est monté avec un microcontrôleur, ce qui permet d'avoir un contrôle sur le profil de courant. De plus, ce microcontrôleur propose des convertisseurs analogique-numérique 16 bits, ce qui permet des mesures grande résolution.

ii. Capteurs de variables réelles :

$T_{bat}$ : le capteur de mesure de la température de la batterie est avantageusement un thermistor qui permet de mesurer la température avec une haute résolution. Il peut s'agir par exemple d'un thermistor de 10 $k\Omega$ connecté au module d'évaluation BC3770. Ce thermistor a un convertisseur analogique-numérique 16 bits, et offre une résolution en température de 0,01°C avec un bruit acceptable.

Le module d'évaluation permet également de mesurer $V_{bat}$ ainsi que le courant des batteries. Ce sont des fonctions natives du module. En ce qui concerne $T_{amb}$ , elle est mesurée au moyen d'un thermistor connecté aux convertisseurs analogiques numériques du microcontrôleur.

iii. Enregistreur de données
iv. Générateur de signaux de courant de charge
v. Unité centrale de commande et calcul

Ces 3 éléments iii., iv. & v. peuvent être rassemblés dans un nano-ordinateur monocarte à processeur ARM, du type raspberry pi 3.

*EXEMPLE*

L'exemple qui suit illustre un mode préféré de mise en oeuvre du procédé selon invention, sur une batterie lithium -Ion.

Batterie : batterie cylindrique 18650 Lithium-Ion (diamètre : 18 mm , hauteur: 65 mm), de capacité nominale de 3070 mAh.

Le dispositif selon l'invention utilisé dans cet exemple est celui décrit ci-dessus.

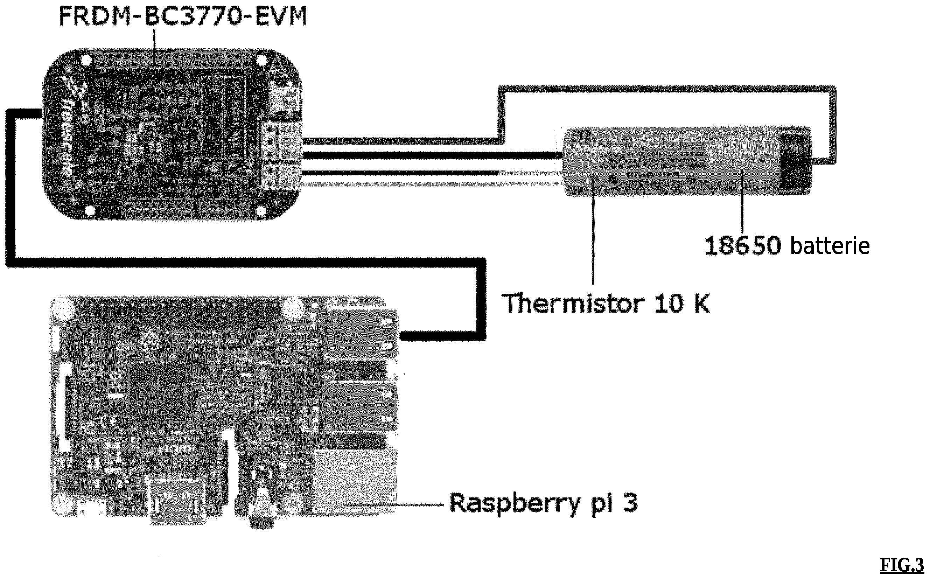

La figure 3 montre le banc test comprenant ce dispositif et la batterie.

Ce banc de test est placé dans une chambre environnementale pour pouvoir contrôler la température de l'air autour de la batterie et éviter des perturbations inutiles.

Le thermistor est mis en contact avec la batterie avec un fluide favorisant le contact thermique, à savoir dans cet exemple la graisse silicone commercialisée par la société VELLEMAN. De plus, il est thermiquement isolé du milieu extérieur au moyen de caoutchouc synthétique.

On considère donc que la température mesurée est la température de surface de la batterie.

*Etape* (a$_0$) *Pré-estimation des paramètres **mC$_p$** et **hA***

Dans notre modèle thermo-électrique, les deux paramètres **mC$_p$ et hA** sont considérés comme constants par rapport à l'état de charge et l'état de santé de la batterie.

Ces deux paramètres sont déterminés une fois pour toutes et sont utilisés dans les modèles électrique et thermique pour une batterie donnée.

Pour estimer ces paramètres, on applique un signal carré, de moyenne nulle, de $\pm$ 1 A avec une période de 20 secondes. Ainsi, on s'affranchit de l'influence de la chaleur générée par la variation d'entropie, en effet sur une période la moyenne de la chaleur générée par $\Delta S$ est égale à zéro.

$$mC_p \frac{dT_{bat}}{dt} = I(V_{bat} - OCV) + hA(T_{bat} - T_{amb}) \tag{3'}$$

On applique le signal carré, après une période de relaxation de la tension de la batterie d'une dizaine de minutes. On a ainsi une valeur de $OCV$ précise. Il ne reste donc plus que deux paramètres inconnus dans l'équation (3'): $mC_p$ et $hA$.

On utilise ensuite le banc de test décrit précédemment ainsi que l'algorithme RLS pour estimer ces deux paramètres.

Le graphique en haut de la figure 4 est la réponse en température de la batterie. Celle du bas est la réponse en tension. On peut à partir de ces signaux et de l'algorithme RLS estimer les paramètres désirés.

Les figures 5 et 6 montrent la convergence de ces deux paramètres. On obtient les valeurs suivantes: • $mC_p$ = 110 $JK^{-1}$ • $hA$ = 0.09 $WK^{-1}$

Cette estimation est ensuite intégrée au modèle thermique. On pourra ensuite estimer les autres paramètres.

*Etapes (a) de charge et (b) de décharge*

On applique une séquence binaire pseudo aléatoire (SBPA) en courant en entrée de la batterie, pour la charger. Par exemple, on génère un signal SBPA entre 0A et 1A comme celui représenté figure 7 , et on le répète. La batterie parvient à un "C rate" de 0,3.C. On procède de même pour la décharge, le signal Sd est entre 0$A$ et -1$A$.

*Etape (e) d'estimation périodique du modèle électrique*

On applique un courant tel que décrit dans le paragraphe précédent en entrée de notre système batterie. On commence par décharger la batterie qui initialement est entièrement chargée. On peut voir la réponse en tension sur la figure 8

Les paramètres intéressants du modèle électrique régit par l'équation 1 sont $R_0$ et $OCV$. $R_0$ est un paramètre utile et souvent utilisé pour une estimation du vieillissement de la batterie. $OCV$ est utile pour le modèle thermique, cela nous permettra de mieux estimer $\Delta S$.

On applique ensuite l'algorithme RLS aux données pour estimer les paramètres du modèle. Les paramètres sont mis à jour toutes les 0.2 secondes. La figure 9 montre l'estimation de $R_0$ en fonction de l'état de charge. L'état de charge est défini grâce à la méthode du coulomb counting. Cela consiste à suivre le courant en l'intégrant durant l'utilisation des batteries. Cette intégration donne de manière directe la quantité de charges électriques injectées ou soutirées à la batterie permettant ainsi de quantifier précisément l'état de charge de la batterie. De même, la figure 10 représente l'estimation de $OCV$.

*Etape (g) d'estimation périodique du modèle thermique*

Comme montré sur la figure 2, l'algorithme RLS de l'estimation périodique du modèle électrique travaille en même temps que l'algorithme RLS de l'estimation périodique du modèle thermique. Le premier, comme dit précédemment va estimer *OCV* à partir du courant et de la tension. Cette estimation va être utilisée par un deuxième algorithme RLS basé sur le modèle thermique et utilisant la température en vue d'estimer $\Delta S$. Il est à noter que la dynamique électrique étant bien plus rapide que la dynamique thermique, la fréquence utilisée pour mettre à jour les paramètres électrique est plus élevée que pour les paramètres thermiques. On obtient ainsi l'estimation figure 11 pour $\Delta S$ en fonction de l'état de charge de la batterie. Une information importante à ajouter est le temps mis pour obtenir le profil complet. Le courant étant en moyenne de 0,5 A, 6 heures ont été nécessaires.

On peut aussi obtenir une estimation de l'enthalpie $\Delta H$ (voir figure 12) car celle ci peut être calculée à partir de *OCV* et $\Delta S$ de la manière suivante: $\Delta H = -F.OCV - T_{bat}\Delta S$

On vient donc d'effectuer une estimation des données thermodynamiques (*OCV,* $\Delta S$ et $\Delta H$) en temps réel avec un algorithme récursif. Il est maintenant nécessaire de comparer ces profils estimés avec les profils mesurés par la méthode standard, l'ETM (electo-chemical thermodynamic measurement).

**Exemple comparatif avec la méthode ETM**

**Banc de test**

En vue de faire la comparaison avec la méthode standard, un banc de test est fabriqué pour faire la mesure. Un schéma de ce banc se trouve figure 13. Il est principalement composé de 9 éléments :

1. Une batterie identique à celle utilisée dans l'exemple selon invention.
2. Un chargeur de batterie identique à celui utilisé dans l'exemple selon l'invention.
3. Un thermistor de 10 $k\Omega$ pour mesurer la température de la batterie.
4. Un boîtier métallique contenant la batterie.
5. Un élément peltier en contact avec le boîtier pour changer la température de ce dernier.
6. Un radiateur pour évacuer la chaleur.
7. Un ventilateur pour refroidir le radiateur.
8. Un Peltier driver pour contrôler la température de la batterie.
9. Un raspberry pi 3 pour contrôler le chargeur et le Peltier driver (donc contrôler la température de la batterie). Il sert aussi à enregistrer les données de courant, de température et de tension de la batterie.

**Mesure des données thermodynamique**

$$\Delta S = F \left(\frac{\partial OCV}{\partial T_{bat}}\right)_x$$

Pour mesurer $\Delta S$ on se base sur la formule suivante:

- $\Delta S$ est la variation d'entropie
- *F* est la constante de Faraday
- *OCV* est la tension en circuit ouvert
- $T_{bat}$ est la température de la batterie
- *x* est l'état de charge

En pratique, pour mesurer $\Delta S$ on se met à un état de charge donné , on coupe le courant et on attend plusieurs heures pour que la tension se relaxe et tende vers *OCV.* Ensuite on fait varier la température de la batterie, ce qui aura pour effet de varier la tension (cette variation est très faible, la mesure doit se faire à haute résolution). S'il n'y a pas de changement de phase (changement de structure cristalline à l'intérieur de l'anode ou la cathode), il existe une relation linéaire entre $T_{bat}$ et *OCV.* Il ne reste plus qu'à déterminer le coefficient reliant les deux et à le multiplier par la constante de faraday pour obtenir $\Delta S$. Pour obtenir un profil complet, il faut réitérer la mesure à différents états de charge.

*OCV* est obtenue directement en mesurant la tension après relaxation et $\Delta H$ est obtenue à l'aide de l'équation : $\Delta H = -F.OCV - T_{bat}\Delta S$

**Comparaison**

On va maintenant comparer les profils obtenus avec la méthode standard et la méthode en ligne. Les figures 14, 15 et 16 permettent de comparer ces deux méthodes. On remarque qu'il existe un biais entre *OCV* mesurée en ligne selon invention et celle mesurée après relaxation selon l'exemple comparatif. Ce biais se répercute ensuite sur

l'estimation de $\Delta H$ et $\Delta S$.

Un autre aspect important de la comparaison est le temps de mesure pour obtenir un profil complet. Avec la méthode ETM de l'exemple comparatif, 5 jours sont nécessaires. Avec le procédé selon invention : 6 heures. On gagne plus d'un ordre de grandeur.

*Répétabilité*

Une caractéristique importante à déterminer est la répétabilité du procédé selon invention. On a donc pour une même batterie estimé plusieurs fois ( 7 fois) les profils thermodynamiques en décharge. On a ensuite tracé les profils moyens et leur intervalle de confiance à 95%. C'est ce que l'on peut observer figure 17, 18 et 19.

Plus que la parfaite compatibilité avec le profil mesuré avec la méthode standard, ce qui est important c'est de s'assurer que la mesure du profil en ligne selon invention, est répétable. En effet, ce profil peut ensuite être utilisé pour estimer l'état de santé de la batterie et c'est sa variation dans le temps qui est importante à cet égard. De même, pour estimer l'état de charge, c'est sa répétabilité qui est importante.

**Revendications**

1. Procédé de mesure, in-situ, en ligne et en temps réel, des données thermodynamiques, en particulier de la variation d'entropie $\Delta S$, d'au moins une batterie, consistant à :

(Phase I) Réaliser une modélisation préalable de la batterie dont l'état de charge (SOC : "State Of Charge") est compris entre 0 et 100% par mise en oeuvre des étapes suivantes :

(a) charger au moins partiellement la batterie avec un signal $Sc$ de courant de charge ;
(b) et/ou décharger au moins partiellement la batterie avec un signal $Sd$ de courant de décharge ;
(c) Mesurer des variables réelles utiles dans les étapes suivantes ;
(d) Modéliser le comportement électrique de la batterie pendant la charge (a) avec un signal $Sc$ de courant de charge et/ou la décharge (b) avec un signal $Sd$ de courant de décharge, pour estimer des paramètres électriques de la batterie ;
(e) Estimer périodiquement, à une fréquence Fe, des paramètres électriques de la batterie ;
(f) Modéliser le comportement thermique de la batterie pendant la charge (a) avec un signal $Sc$ de courant de charge et/ou la décharge (b) avec un signal $Sd$ de courant de décharge, pour estimer in-situ, en ligne et en temps réel, au moins l'un des paramètres du modèle thermique, à savoir $\Delta S$ ;
(g) Estimer périodiquement, à une fréquence Fg, au moins l'un des paramètres du modèle thermique, en particulier $\Delta S$, en utilisant au moins l'un des paramètres électriques estimés à l'étape (e) ;

(Phase II) Mesurer des données thermodynamiques, en particulier $\Delta S$, de la batterie en cours d'utilisation dans une application et à un état de charge quelconque, en mettant en oeuvre les modèles électrique [étape (d)] et thermique [étape (f)] de la phase I, l'estimation des paramètres électriques [étape (e)] et l'estimation d'au moins l'un des paramètres du modèle thermique, en particulier $\Delta S$ [étape (g)];
(Phase III) Eventuellement stocker les données mesurées/calculées lors de la phase II et /ou de la phase I,
Le procédé étant **caractérisé en ce que** :

- > La modélisation de l'étape (d) consiste à considérer que la batterie est un circuit électrique ou modèle électrique comprenant une résistance $R_0$, une tension en circuit ouvert $OCV$, et un circuit $R_1C_1$ en série ;

le comportement électrique de la batterie étant décrit, dans ce modèle, par les équations suivantes :

$$\begin{cases} \dot{U}_1 &= -\frac{1}{C_1 R_1} U_1 + \frac{1}{C_1} I \qquad (1) \\[2ex] V_{bat} &= OCV + U_1 + R_0 I \qquad (2) \end{cases}$$

où $U_1$ est la tension aux bornes du circuit RC, $I$ est le courant traversant la batterie et $V_{bat}$ la tension aux bornes de la batterie.
l'équation (2) étant discrétisée comme suit :

$$V_{bat,k} = I_k b_{0,k} + I_{k-1} b_{1,k} + a_{1,k}(OCV_{k-1} - V_{bat,k-1}) + OCV_k \qquad (2')$$

et réécrite ainsi :

$$V_{bat,k} = \Theta_k^T \Phi_k \qquad (2'')$$

avec :
où :

$$\begin{cases} \Theta_k^T & = & [b_{0,k} \quad b_{1,k} \quad a_{1,k} \quad OCV_k] \\ \\ \Phi_k^T & = & [I_k \quad I_{1,k-1} \quad (OCV_{k-1} - V_{bat,k-1}) \quad ] \end{cases}$$

$$\begin{cases} b_0 & = & R_0 \\ \\ b_1 & = & -R_0 + \dfrac{T_s}{C_1} + \dfrac{T_s R_0}{C_1 R_1} \\ \\ a_1 & = & \dfrac{T_s}{C_1 R_1} - 1 \end{cases}$$

$T_s$ est la période d'échantillonnage du signal $S_e$ ;

$\Theta_k^T$ est le vecteur paramètres ;

- > La modélisation de l'étape (f) consiste à considérer la batterie comme un modèle thermique dans lequel la batterie, d'une part, est soumise à un courant *Sc* de charge apte à être soumis à un échantillonnage ou à un courant *Sd* de décharge apte à être soumis à un échantillonnage, et, d'autre part, est un échangeur de chaleur avec son environnement et dans lequel le comportement thermique de la batterie est décrit par l'équation suivante :

$$mC_p \frac{dT_{bat}}{dt} = I(V_{bat} - OCV) + IT_{bat}\frac{\Delta S}{F} + hA(T_{bat} - T_{amb}) \qquad (3)$$

où :

- *m* est la masse de la batterie
- $C_p$ est la capacité calorifique de la batterie
- $T_{bat}$ est la température de la batterie
- *t* est la variable temps
- *I* est le courant traversant la batterie
- $V_{bat}$ est la tension aux bornes de la batterie
- *OCV* est la tension en circuit ouvert de la batterie
- $\Delta S$ est la variation d'entropie de la batterie
- *F* est la constante de Faraday
- *h* est le coefficient d'échange thermique avec l'extérieur
- *A* est l'aire de la batterie en contact l'extérieur
- $T_{amb}$ est la température du milieu extérieur

l'équation (3) étant discrétisée comme suit :

$$T_{bat,k} - T_{bat,k-1} = a_{0,k}[I_k(V_{bat,k} - OCV_k)] + a_{1,k}I_k T_{bat,k} + a_{2,k}(T_{bat,k} - T_{amb,k}) \quad (4)$$

et réécrite ainsi :

$$T_{bat,k} - T_{bat,k-1} = \Theta_k^T \Phi_k \tag{5}$$

avec :

$$\begin{cases} \Theta_k^T & = & [a_{0,k} \quad a_{1,k} \quad a_{2,k}] \\ \Phi_k & = & [I_k(V_{bat,k} - OCV_k) \quad I_k T_{bat,k} \quad T_{bat,k} - T_{amb,k}] \end{cases}$$

où :

$$\begin{cases} a_0 & = & \dfrac{T_s}{mC_p} \\ a_1 & = & \dfrac{T_s \Delta S}{mC_p F} \\ a_2 & = & \dfrac{T_s hA}{mC_p} \end{cases} \text{soit} \begin{cases} mC_p & = & \dfrac{T_s}{a_0} \\ \Delta S & = & \dfrac{a_1 F}{a_0} \\ hA & = & \dfrac{a_2}{a_0} \end{cases}$$

$T_s$ est la période d'échantillonnage de mesure.

2. Procédé selon la revendication 1, **caractérisé en ce que** les produits $mC_p$ et $hA$ sont constants et **en ce qu'**ils sont estimés dans une étape ($a_0$) préalable à l'étape (a) qui consiste essentiellement à :

    - Mettre en oeuvre une relaxation de la batterie afin que le paramètre $OCV$ de l'équation (2') du modèle électrique, ait une valeur donnée précise ;
    - Appliquer un signal électrique d'entrée $S_e$ périodique dont la période est choisie de telle sorte que la moyenne de la chaleur générée par $\Delta S$ sur une période soit de l'ordre de 0, $S_e$ étant de préférence un signal carré de période comprise entre 10 et 30 secondes, idéalement de l'ordre de 20 secondes, ce signal carré étant plus préférentiellement encore de moyenne nulle ;
    - Estimer les produits $mC_p$ et $hA$, de préférence au moyen d'un algorithme des moindres carrés récursifs, grâce à l'équation (3) devenue l'équation (3') suivante:

$$mC_p \frac{dT_{bat}}{dt} = I(V_{bat} - OCV) + hA(T_{bat} - T_{amb}) \tag{3'}$$

    et par mesure des variables réelles correspondant aux paramètres $V_{Bat}$, $I$, $T_{bat}$, $T_{amb}$
    - Intégrer cette estimation des produits $mC_p$ et $hA$ dans le modèle thermique pour les étapes (f) & (g).

3. Procédé selon l'une au moins des revendications précédentes, **caractérisé en ce que** les variables réelles mesurées à l'étape (c) correspondent aux paramètres $V_{Bat}$, $I$, $T_{bat}$, $T_{amb}$ des modèles électrique et thermique.

4. Procédé selon l'une au moins des revendications précédentes **caractérisé en ce que** l'estimation selon l'étape (e) est réalisée au moyen d'un algorithme des moindres carrés récursifs et **en ce que** l'estimation selon l'étape (g) est réalisée au moyen d'un algorithme des moindres carrés récursifs.

5. Procédé selon la revendication 1, éventuellement selon l'une au moins des revendications 2 à 4, **caractérisé en ce que** pour la mise en oeuvre de l'étape (a) de charge, on applique, de manière répétitive, un courant de charge $Sc$, dont la gamme de fréquences est comprise entre 0 et 1 Hz, de préférence un signal correspondant à une Séquence Binaire Pseudo Aléatoire -SBPA-, ce signal étant choisi de telle sorte que le "C rate" de la batterie soit compris entre 0,01.C et 3.C, de préférence entre 0,1.C et 2,5.C, et, plus préférentiellement encore entre 0,2.C et 2.C.

**6.** Procédé selon la revendication 1, éventuellement selon l'une au moins des revendications 2 à 5, **caractérisé en ce que** pour la mise en oeuvre de l'étape (b) de décharge, on applique, de manière répétitive, un courant de décharge *Sd* qui est le courant d'entrée *Se,* dont la gamme de fréquences est comprise entre 0 et 1 Hz, de préférence un signal correspondant à une Séquence Binaire Pseudo Aléatoire -SBPA-, ce signal étant choisi de telle sorte que le "C rate" de la batterie soit compris entre 0,01.C et 3.C, de préférence entre 0,1.C et 2,5.C, et, plus préférentiellement encore entre 0,2.C et 2.C.

**7.** Procédé selon la revendication 1, éventuellement selon l'une au moins des revendications 2 à 6, **caractérisé en ce que** l'on estime la variation d'enthalpie *ΔH* à partir de *OCV* et *ΔS* à l'aide de l'équation suivante :

$$\Delta H = -F.OCV - T_{bat}\Delta S \qquad (6)$$

**8.** Procédé de détermination de l'état de charge et/ou de l'état de santé d'une batterie à partir de *ΔS* et/ou de *ΔH* mesuré par le procédé selon l'une au moins des revendications précédentes.

**9.** Dispositif configuré pour mettre en oeuvre le procédé selon l'une au moins des revendications 2 à 8, **caractérisé en ce qu'**il comprend :

i. Au moins un chargeur/déchargeur programmable ;
ii. Au moins un capteur d'au moins l'une des variables réelles qui correspondent aux paramètres suivants : $V_{Bat}$, $I$, $T_{bat}$, $T_{amb}$ ;
iii. Au moins un enregistreur de données ;
iv. Au moins un générateur de signaux de courant de charge ;
v. au moins une unité centrale de commande et de calcul apte à contrôler le ou les éléments (i)(ii)(iii)(iv), à recueillir et à traiter les données selon les estimations des étapes ($a_0$) (e) & (g), de préférence en implémentant des algorithmes des moindres carrés récursifs.

**Patentansprüche**

**1.** Verfahren zur Messung in situ, online und in Echtzeit von thermodynamischen Daten, insbesondere der Änderung der Entropie *ΔS*, von mindestens einer Batterie, bestehend aus:

(Phase I) Durchführung einer vorgängigen Modellierung der Batterie, deren Ladezustand (SOC "State of Charge") zwischen 0 und 100 % ist, pro Ausführung der folgenden Schritte:

(a) mindestens teilweises Laden der Batterie mit einem Signal *Sc* des Ladestroms;
(b) und/oder mindestens teilweises Entladen der Batterie mit einem Signal *Sd* des Entladestroms;
(c) Messen der nützlichen realen Variablen in den folgenden Schritten;
(d) Modellieren des elektrischen Verhaltens der Batterie während dem Ladevorgang (a) mit einem Signal *Sc* des Ladestroms und/oder der Entladung (b) mit einem Signal *Sd* des Entladestroms, um elektrische Parameter der Batterie zu schätzen;
(e) periodisches Schätzen, bei einer Frequenz Fe, der elektrischen Parameter der Batterie;
(f) Modellieren des thermischen Verhaltens der Batterie während des Ladevorgangs (a) mit einem Signal *Sc* des Ladestroms und/oder der Entladung (b) mit einem Signal *Sd* des Entladestroms, um in situ, online und in Echtzeit mindestens einen der Parameter des thermischen Modells zu schätzen, und zwar *ΔS*;
(g) periodisches Schätzen, bei einer Frequenz Fg, von mindestens einem der Parameter des thermischen Modells, insbesondere *ΔS*, unter Verwendung von mindestens einem der elektrischen Parameter; die in Schritt (e) geschätzt wurden;

(Phase II) Messung der thermodynamischen Daten, insbesondere *ΔS*, der Batterie, die in einer Anwendung und in einem beliebigen Ladezustand verwendet wird, durch Ausführung der elektrischen [Schritt (d)] und thermischen [Schritt (f)] Modelle der Phase I, der Schätzung der elektrischen Parameter [Schritt (e)] und der Schätzung von mindestens einem der Parameter des thermischen Modells, insbesondere *ΔS* [Schritt (g)];
(Phase III) gegebenenfalls Speichern der in Phase II und/oder Phase I gemessenen/berechneten Daten;
wobei das Verfahren **dadurch gekennzeichnet ist, dass**:

→ die Modellierung von Schritt (d) darin besteht, zu berücksichtigen, dass die Batterie eine elektrische Schaltung oder ein elektrisches Modell ist, das einen Widerstand $R_0$, eine Leerlaufspannung $OCV$ und eine Serienschaltung $R_1 C_1$ umfasst;

wobei das elektrische Verhalten der Batterie beschrieben wird, in diesem Modell, durch die folgenden Gleichungen:

$$\begin{cases} \dot{U}_1 & = & -\frac{1}{C_1 R_1} U_1 + \frac{1}{C_1} I \qquad (1) \\ \\ V_{bat} & = & OCV + U_1 + R_0 I \qquad (2) \end{cases}$$

wobei $U_1$ die Spannung an den Klemmen der Schaltung RC ist, $I$ der Strom ist, der durch die Batterie fließt, und $V_{bat}$ die Spannung an den Klemmen der Batterie ist.
Wobei die Gleichung (2) wie folgt diskretisiert wird:

$$V_{bat,k} = I_k b_{0,k} + I_{k-1} b_{1,k} + a_{1,k}(OCV_{k-1} - V_{bat,k-1}) + OCV_k \qquad (2')$$

und so umgeschrieben wird:

$$V_{bat,k} = \Theta_k^T \Phi_k \qquad (2'')$$

mit:

$$\begin{cases} \Theta_k^T & = & [b_{0,k} \quad b_{1,k} \quad a_{1,k} \quad OCV_k] \\ \\ \Phi_k^T & = & [I_k \quad I_{1,k-1} \quad (OCV_{k-1} - V_{bat,k-1}) \qquad ] \end{cases}$$

wobei:

$$\begin{cases} b_0 & = & R_0 \\ \\ b_1 & = & -R_0 + \frac{T_s}{C_1} + \frac{T_s R_0}{C_1 R_1} \\ \\ a_1 & = & \frac{T_s}{C_1 R_1} - 1 \end{cases}$$

wobei $Ts$ die Abtastperiode des Signals $S_e$ ist;

$\Theta_k^T$ der Vektorparameter ist;

→ die Modellierung von Schritt (f) darin besteht, zu berücksichtigen, dass die Batterie ein thermisches Modell ist, wobei die Batterie einerseits einem Ladestrom $Sc$ ausgesetzt ist, der dazu geeignet ist, einer Abtastung unterzogen zu werden, oder einem Entladestrom $Sd$, der dazu geeignet ist, einer Abtastung unterzogen zu werden, und andererseits ein Wärmetauscher ist mit seinem Umfeld, und wobei das thermische Verhalten der Batterie durch die folgende Gleichung beschrieben wird:

$$mC_p \frac{dT_{bat}}{dt} = I(V_{bat} - OCV) + IT_{bat}\frac{\Delta S}{F} + hA(T_{bat} - T_{amb}) \tag{3}$$

wobei:

- $m$ die Masse der Batterie ist;
- $C_p$ die Wärmekapazität der Batterie ist;
- $T_{bat}$ die Temperatur der Batterie ist;
- $t$ die Zeitvariable ist;
- $I$ der Strom ist, der durch die Batterie fließt;
- $V_{bat}$ die Spannung an den Klemmen der Batterie ist;
- $OCV$ die Leerlaufspannung der Batterie ist;
- $\Delta S$ die Änderung der Entropie der Batterie ist;
- $F$ die Faradaysche Konstante ist;
- $h$ der Koeffizient des Wärmeaustausches mit dem Außenbereich ist;
- $A$ der Bereich der Batterie in Kontakt mit dem Außenbereich ist;
- $T_{amb}$ die Temperatur des Umgebungsbereichs ist,

wobei die Gleichung (3) wie folgt diskretisiert wird:

$$T_{bat,k} - T_{bat,k-1} = a_{0,k}[I_k(V_{bat,k} - OCV_k)] + a_{1,k}I_k T_{bat,k} + a_{2,k}(T_{bat,k} - T_{amb,k}) \tag{4}$$

und so umgeschrieben wird:

$$T_{bat,k} - T_{bat,k-1} = \Theta_k^T \Phi_k \tag{5}$$

mit:

$$\begin{cases} \Theta_k^T &= & [a_{0,k} \quad a_{1,k} \quad a_{2,k}] \\ \Phi_k &= & [I_k(V_{bat,k} - OCV_k) \quad I_k T_{bat,k} \quad T_{bat,k} - T_{amb,k}] \end{cases}$$

wobei:

$$\begin{cases} a_0 &= & \frac{T_s}{mC_p} \\ a_1 &= & \frac{T_s \Delta S}{mC_p F} \\ a_2 &= & \frac{T_s hA}{mC_p} \end{cases} \text{soit} \begin{cases} mC_p &= & \frac{T_s}{a_0} \\ \Delta S &= & \frac{a_1 F}{a_0} \\ hA &= & \frac{a_2}{a_0} \end{cases}$$

wobei $Ts$ die Abtastperiode der Messung ist.

2. Verfahren nach Anspruch 1, **dadurch gekennzeichnet, dass** die Produkte $mC_p$ und $hA$ konstant sind, und dass sie in einem Schritt ($a_0$) vorgängig zum Schritt (a) geschätzt werden, der im Wesentlichen besteht aus:

- Ausführung einer Relaxation der Batterie, so dass der Parameter $OCV$ der Gleichung (2') des elektrischen Modells einen genauen gegebenen Wert hat;
- Anlegen eines periodischen elektrischen Eingangssignals Se, dessen Periode so gewählt ist, dass der Mittelwert der Wärme, die von $\Delta S$ über eine Periode erzeugt wird, in der Größenordnung von 0 liegt, wobei $S_e$

vorzugsweise ein Rechtecksignal mit einer Periode zwischen 10 und 30 Sekunden ist, idealerweise in der Größenordnung von 20 Sekunden, wobei dieses Rechtecksignal noch bevorzugter einen Mittelwert von null hat;
- Schätzung der Produkte $mC_p$ und $hA$, vorzugsweise mittels eines Algorithmus der Methode der kleinsten Quadrate, durch die Gleichung (3), die zur folgenden Gleichung (3') wurde:

$$mC_p \frac{dT_{bat}}{dt} = I(V_{bat} - OCV) + hA(T_{bat} - T_{amb}) \qquad (3')$$

und durch Messung der realen Variablen, die den Parametern $V_{Bat}$, $I$, $T_{bat}$, $T_{amb}$ entsprechen;
- Integrieren dieser Schätzung der Produkte $mC_p$ und $hA$ in das thermische Modell für die Schritte (f) & (g).

3. Verfahren nach mindestens einem der vorhergehenden Ansprüche, **dadurch gekennzeichnet, dass** die realen Variablen, die in Schritt (c) gemessen werden, den Parametern $V_{Bat}$, $I$, $T_{bat}$, $T_{amb}$ der elektrischen und thermischen Modelle entsprechen.

4. Verfahren nach mindestens einem der vorhergehenden Ansprüche, **dadurch gekennzeichnet, dass** die Schätzung gemäß Schritt (e) mittels eines Algorithmus der Methode der kleinsten Quadrate durchgeführt wird und dass die Schätzung gemäß Schritt (g) mittels eines Algorithmus der Methode der kleinsten Quadrate durchgeführt wird.

5. Verfahren nach Anspruch 1, gegebenenfalls nach mindestens einem der Ansprüche 2 bis 4, **dadurch gekennzeichnet, dass** zur Ausführung des Schrittes (a) der Ladung ein Ladestrom $Sc$ wiederholt angelegt wird, dessen Frequenzbereich zwischen 0 und 1 Hz liegt, vorzugsweise ein Signal, das einer Pseudorandom Binary Sequence -PRBSentspricht, wobei dieses Signal so gewählt wird, dass die "C-Rate" der Batterie zwischen 0,01.C und 3.C liegt, vorzugsweise zwischen 0,1.C und 2,5.C, und noch bevorzugter zwischen 0,2.C und 2.C.

6. Verfahren nach Anspruch 1, gegebenenfalls nach mindestens einem der Ansprüche 2 bis 5, **dadurch gekennzeichnet, dass** zur Ausführung des Schrittes (b) der Entladung ein Entladestrom $Sd$ wiederholt angelegt wird, der der Eingangsstrom $S_e$ ist, dessen Frequenzbereich zwischen 0 und 1 Hz liegt, vorzugsweise ein Signal, das einer Pseudorandom Binary Sequence -PRBS- entspricht, wobei dieses Signal so gewählt wird, dass die "C-Rate" der Batterie zwischen 0,01.C und 3.C liegt, vorzugsweise zwischen 0,1.C und 2,5.C, und noch bevorzugter zwischen 0,2.C und 2.C.

7. Verfahren nach Anspruch 1, gegebenenfalls nach mindestens einem der Ansprüche 2 bis 6, **dadurch gekennzeichnet, dass** die Änderung der Enthalpie $\Delta H$ ausgehend von $OCV$ und $\Delta S$ mithilfe der folgenden Gleichung geschätzt wird:

$$\Delta H = -F.OCV - T_{bat}\Delta S \qquad (6)$$

8. Verfahren zur Bestimmung des Ladezustands und/oder des Allgemeinzustands einer Batterie ausgehend von $\Delta S$ und/oder $\Delta H$, gemessen durch das Verfahren nach mindestens einem der vorhergehenden Ansprüche.

9. Vorrichtung zur Ausführung des Verfahrens nach mindestens einem der Ansprüche 2 bis 8, **dadurch gekennzeichnet, dass** sie umfasst:

   i. mindestens ein programmierbares Lade-/Entladegerät;
   ii. mindestens einen Sensor von mindestens einer der realen Variablen, die den folgenden Parametern entsprechen: $V_{Bat}$, $I$, $T_{bat}$, $T_{amb}$;
   iii. mindestens einen Datenlogger;
   iv. mindestens einen Signalerzeuger des Ladestroms;
   v. mindestens eine zentrale Steuerungs- und Recheneinheit, die geeignet ist, das oder die Elemente (i) (ii) (iii) (iv) zu steuern, und die Daten nach den Schätzungen der Schritte ($a_0$), (e) & (g) zu sammeln und zu verarbeiten, vorzugsweise durch Implementierung von Algorithmen der Methode der kleinsten Quadrate.

**Claims**

1. A process for measuring thermodynamic data, in particular the entropy variation $\Delta S$, of at least one battery, in-situ, online and in real time, consisting in:

   (Phase I) Carrying out a preliminary modelling of the battery whose state of charge (SOC) is comprised between 0 and 100% by implementing the following steps:

   (a) at least partially charging the battery with a charging current signal $Sc$;
   (b) and/or at least partially discharging the battery with a discharging current signal $Sd$;
   (c) Measuring real variables which are useful in the following steps;
   (d) Modelling the electrical behaviour of the battery during charging (a) with a charging current signal $Sc$ and/or discharging (b) with a discharging current signal $Sd$, to estimate electrical parameters of the battery;
   (e) Periodically estimating, at a frequency Fe, electrical parameters of the battery;
   (f) Modelling the thermal behaviour of the battery during charging (a) with a charging current signal $Sc$ and/or discharging (b) with a discharging current signal $Sd$, to estimate at least one of the parameters of the thermal model, namely $\Delta S$, in-situ, online and in real time;
   (g) Periodically estimating, at a frequency Fg, at least one of the parameters of the thermal model, in particular $\Delta S$, using at least one of the electrical parameters estimated in step (e);

   (Phase II) Measuring thermodynamic data, in particular $\Delta S$, of the battery in use in an application and at any state of charge, by implementing the electrical [step (d)] and thermal [step (f)] models of the phase I, the estimate of the electrical parameters [step (e)] and the estimate of at least one of the parameters of the thermal model, in particular $\Delta S$ [step (g)];
   (Phase III) Possibly storing the data measured/calculated during phase II and/or phase I,
   The process being **characterised in that**:

   $\rightarrow$ The modelling of step (d) consists in considering that the battery is an electrical circuit or electrical model comprising a resistor $R_0$, an open circuit voltage $OCV$, and a series circuit $R_1C_1$;

   the electrical behaviour of the battery being described, in this model, by the following equations:

   $$\begin{cases} \dot{U}_1 & = & -\dfrac{1}{C_1 R_1} U_1 + \dfrac{1}{C_1} I & (1) \\ \\ V_{bat} & = & OCV + U_1 + R_0 I & (2) \end{cases}$$

   where $U_1$ is the voltage across the circuit RC, $I$ is the current flowing through the battery and $V_{bat}$ the voltage across the battery.
   the equation (2) being discretised as follows:

   $$V_{bat,k} = I_k b_{0,k} + I_{k-1} b_{1,k} + a_{1,k}(OCV_{k-1} - V_{bat,k-1}) + OCV_k \qquad (2')$$

   and rewritten as follows:

   $$V_{bat,k} = \Theta_k^T \Phi_k \qquad (2'')$$

   with:

   $$\begin{cases} \Theta_k^T & = & [b_{0,k} \quad b_{1,k} \quad a_{1,k} \quad OCV_k] \\ \\ \Phi_k^T & = & [I_k \quad I_{1,k-1} \quad (OCV_{k-1} - V_{bat,k-1}) \quad ] \end{cases}$$

where:

$$\begin{cases} b_0 &= R_0 \\[2mm] b_1 &= -R_0 + \dfrac{T_s}{C_1} + \dfrac{T_s R_0}{C_1 R_1} \\[4mm] a_1 &= \dfrac{T_s}{C_1 R_1} - 1 \end{cases}$$

$T_s$ is the sampling period of the signal $S_e$;

$\Theta_k^T$ is the parameters vector;

- The modelling of step (f) consists in considering the battery as a thermal model in which the battery, on the one hand, is subjected to a charging current *Sc* capable of being subjected to a sampling, or, on the other hand, to a discharging current *Sd* capable of being subjected to a sampling, and, on the other hand, is a heat exchanger with its environment and in which the thermal behaviour of the battery is described by the following equation:

$$mC_p \frac{dT_{bat}}{dt} = I(V_{bat} - OCV) + IT_{bat}\frac{\Delta S}{F} + hA(T_{bat} - T_{amb}) \tag{3}$$

where:

- $m$ is the mass of the battery
- $C_p$ is the heat capacity of the battery
- $T_{bat}$ is the temperature of the battery
- t is the time variable
- $I$ is the current flowing through the battery
- $V_{bat}$ is the voltage across the battery
- $OCV$ is the open circuit voltage of the battery
- $\Delta S$ is the entropy variation of the battery
- $F$ is Faraday constant
- $h$ is the heat exchange coefficient with the outside
- $A$ is the area of the battery in contact with the outside
- $T_{amb}$ is the temperature of the external environment

the equation (3) being discretised as follows:

$$T_{bat,k} - T_{bat,k-1} = a_{0,k}[I_k(V_{bat,k} - OCV_k)] + a_{1,k}I_k T_{bat,k} + a_{2,k}(T_{bat,k} - T_{amb,k}) \tag{4}$$

- and rewritten as follows:

$$T_{bat,k} - T_{bat,k-1} = \Theta_k^T \Phi_k \tag{5}$$

- with:

$$\begin{cases} \Theta_k^T &= \begin{bmatrix} a_{0,k} & a_{1,k} & a_{2,k} \end{bmatrix} \\ \Phi_k &= \begin{bmatrix} I_k(V_{bat,k} - OCV_k) & I_k T_{bat,k} & T_{bat,k} - T_{amb,k} \end{bmatrix} \end{cases}$$

- where:

$$\begin{cases} a_0 &= \dfrac{T_s}{mC_p} \\ a_1 &= \dfrac{T_s \Delta S}{mC_p F} \\ a_2 &= \dfrac{T_s hA}{mC_p} \end{cases} \text{ i.e. } \begin{cases} mC_p &= \dfrac{T_s}{a_0} \\ \Delta S &= \dfrac{a_1 F}{a_0} \\ hA &= \dfrac{a_2}{a_0} \end{cases}$$

- $T_s$ is the measurement sampling period.

2. The process according to claim 1, **characterised in that** the products $mC_p$ and $hA$ are constant and **in that** they are estimated in a step ($a_0$) prior to step (a) which essentially consists in:

- Implementing a relaxation of the battery so that the parameter $OCV$ of the equation (2') of the electrical model, has an accurate given value;
- Applying a periodic electrical input signal $S_e$ whose period is selected such that the average of the heat generated by $\Delta S$ over a period is in the range of 0, $S_e$ preferably being a square signal with a period comprised between 10 and 30 seconds, ideally in the range of 20 seconds, this square signal being even more preferably of zero average;
- Estimating the products $mC_p$ and $hA$, preferably by means of a recursive least squares algorithm, thanks to the equation (3) becoming the following equation (3'):

$$mC_p \frac{dT_{bat}}{dt} = I(V_{bat} - OCV) + hA(T_{bat} - T_{amb}) \qquad (3')$$

and by measuring the real variables corresponding to the parameters $V_{Bat}$, $I$, $T_{bat}$, $T_{amb}$;
- Integrating this estimate of the products $mC_p$ and $hA$ into the thermal model for the steps (f) & (g).

3. The process according to at least one of the preceding claims, **characterised in that** the real variables measured in step (c) correspond to the parameters $V_{Bat}$, $I$, $T_{bat}$, $T_{amb}$ of the electrical and thermal models.

4. The process according to at least one of the preceding claims **characterised in that** the estimate according to step (e) is carried out by means of a recursive least squares algorithm and **in that** the estimate according to step (g) is carried out by means of a recursive least squares algorithm.

5. The process according to claim 1, possibly according to at least one of claims 2 to 4, **characterised in that** for the implementation of step (a) of charging, a charging current $Sc$ is applied, repeatedly, whose frequency range is comprised between 0 and 1 Hz, preferably a signal corresponding to a pseudo-random binary sequence -PRBS-, this signal being selected such that the "C rate" of the battery is comprised between 0.01.C and 3.C, preferably between 0.1.C and 2.5.C, and, even more preferably between 0.2.C and 2.C.

6. The process according to claim 1, possibly according to at least one of claims 2 to 5, **characterised in that** for the implementation of step (b) of discharging, a discharging current $Sd$ which is the input current $Se$ is applied, repetitively, whose frequency range is comprised between 0 and 1 Hz, preferably a signal corresponding to a pseudo-random binary sequence -PRBS-, this signal being selected such that the "C rate" of the battery is comprised between 0.01.C and 3.C, preferably between 0.1.C and 2.5.C, and, even more preferably between 0.2.C and 2.C.

7.  The process according to claim 1, possibly according to at least one of claims 2 to 6, **characterised in that** the enthalpy variation $\Delta H$ is estimated from $OCV$ and $\Delta S$ using the following equation:

$$\Delta H = -F.OCV - T_{bat}\Delta S \qquad (6)$$

8.  The process for determining the state of charge and/or the state of health of a battery from $\Delta S$ and/or $\Delta H$ measured by the process according to at least one of the preceding claims.

9.  A device configured to implement the method according to at least one of claims 2 to 8, **characterised in that** it comprises:

    i. At least one programmable charger/discharger;
    ii. At least one sensor of at least one of the real variables which correspond to the following parameters: $V_{Bat}$, $I$, $T_{bat}$, $T_{amb}$;
    iii. At least one data logger;
    iv. At least one charging current signal generator;
    y. at least one central control and computing unit capable of controlling the element (s) (i) (ii) (iii) (iv), of collecting and processing the data according to the estimates of steps $(a_0)$ (e) & (g), preferably by implementing recursive least squares algorithms.

**FIG.1**

$V_{bat}$

$I$

$R_o$

$U_d$

$U_1$

$R_1$

$C_1$

OCV

Courant → [Modèle électrique — RLS 1 mis à jour toutes les 0.2 secondes] → OCV estimée →

Tension →

Température → [Modèle thermique — RLS 2 mis à jour toutes les 5 secondes] → ΔS estimée

EP 3 857 639 B1

**FIG.2**

FRDM-BC3770-EVM

18650 batterie

Thermistor 10 K

Raspberry pi 3

EP 3 857 639 B1

**FIG.3**

FIG.4

FIG.6

EP 3 857 639 B1

FIG.7

EP 3 857 639 B1

**FIG.8**

**FIG.9**

FIG.10

FIG.11

EP 3 857 639 B1

**FIG.12**

FRDM-BC3770-EVM

Raspberry pi 3

Boîtier métallique

Thermistor 10 K

18650 batterie

Element peltier

Radiateur

5 V

Ventilateur

Peltier driver

**FIG.13**

**FIG.14**

EP 3 857 639 B1

**FIG.15**

**FIG.16**

EP 3 857 639 B1

FIG.17

EP 3 857 639 B1

**FIG.18**

FIG.19

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1924849 A
- US 8446127 B
- US 9599584 B
- US 20160146895 A
- WO 2017204750 A
- US 2016146895 A1

**Littérature non-brevet citée dans la description**

- **V.-H. DUONG ; H. A. BASTAWROUS ; K. LIM ; K. W. SEE ; P. ZHANG ; S. X. DOU.** Online state of charge and model parameters estimation of the LiFePO4 battery in electric vehicles using multiple adaptive forgetting factors recursive least-squares. *JOURNAL Of POWER SOURCES,* 20 Novembre 2015, vol. 296, 215-224